(19) Europäisches Patentamt
European Patent Office
Office européen des brevets

(11) **EP 4 776 345 A1**

(12) **EUROPEAN PATENT APPLICATION**

(43) Date of publication:
**15.07.2026 Bulletin 2026/29**

(21) Application number: **25223610.4**

(22) Date of filing: **15.12.2025**

(51) International Patent Classification (IPC):
***H01M 4/58*** *(2010.01)* ***G01R 31/367*** *(2019.01)*
***G01R 31/378*** *(2019.01)* ***G01R 31/382*** *(2019.01)*
***G01R 31/387*** *(2019.01)* ***H01M 10/42*** *(2006.01)*
***H01M 10/48*** *(2006.01)*

(52) Cooperative Patent Classification (CPC):
**H01M 10/425; G01R 31/367; G01R 31/378; G01R 31/382; G01R 31/387; H01M 4/5825; H01M 10/4264; H01M 10/4285; H01M 10/48;**
H01M 2010/4278

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.01.2025 KR 20250003702**

(71) Applicant: **SAMSUNG SDI CO., LTD.**
**Yongin-si, Gyeonggi-do 17084 (KR)**

(72) Inventor: **KIM, Hwa-Su**
**17084 Yongin-si (KR)**

(74) Representative: **Marks & Clerk LLP**
**15 Fetter Lane**
**London EC4A 1BW (GB)**

(54) **APPARATUS AND METHOD OF GENERATING LFP BATTERY MODEL**

(57) Disclosed are an apparatus and a method of generating a lithium iron phosphate ($LiFePO_4$, LFP) battery model. The apparatus includes: a lithium state recorder configured to record a state of lithium (Li) in a positive electrode active material of an LFP battery according to charging or discharging of the LFP battery; and a battery model generator configured to generate a battery model of the LFP battery based on the recorded state of the Li in the positive electrode active material. The battery model generator may generate the battery model by modeling the LFP battery through adding an additional voltage increment corresponding to a charging or discharging path of the LFP battery to an open circuit voltage (OCV), in consideration of the state of the Li in the positive electrode active material.

FIG. 1

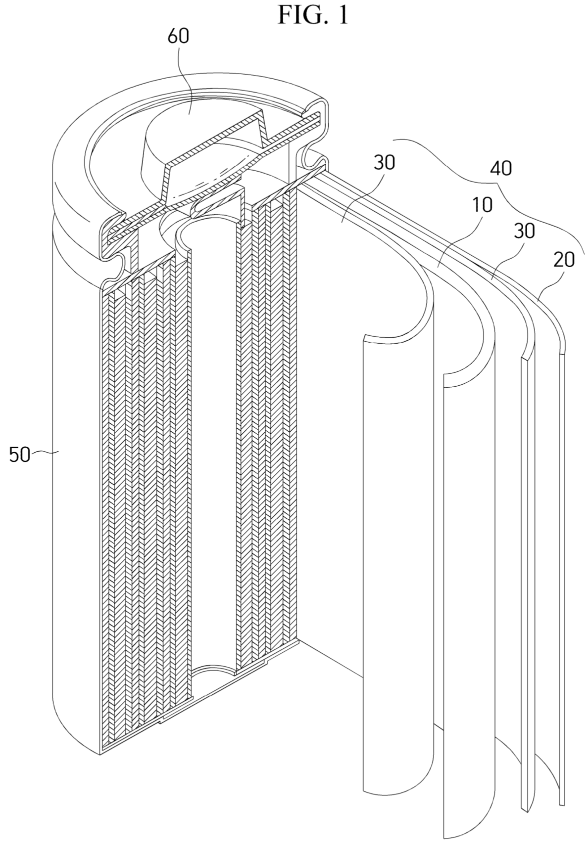


EP 4 776 345 A1

## Description

## FIELD

The present disclosure relates to an apparatus and a method of generating a lithium iron phosphate ($LiFePO_4$, LFP) battery model, and more particularly, to an apparatus and a method of generating an LFP battery model, which record a state of lithium (Li) in a positive electrode active material of an LFP battery according to charging or discharging of the LFP battery, and generate a battery model of the LFP battery based on the recorded state of the lithium in the positive electrode active material.

## BACKGROUND

Unlike primary batteries that are not designed to be charged, secondary batteries are designed to be discharged and recharged. Low-capacity secondary batteries are used in small portable electronic devices, such as smart phones, feature phones, notebook computers, digital cameras, and camcorders, while large-capacity secondary batteries are widely used as power sources for driving motors, such as of hybrid vehicles or electric vehicles, and for power storage. The secondary battery includes an electrode assembly consisting of a positive electrode and a negative electrode, a case that accommodates the electrode assembly, a terminal part connected to the electrode assembly, etc.

Lithium-ion batteries may be classified according to a material constituting a positive electrode material. Based on the positive electrode material, the lithium-ion batteries are classified into a ternary battery and a quaternary battery, which are formed of a lithium cobalt oxide (LCO) positive electrode material, and a lithium iron phosphate ($LiFePO_4$, LFP) battery, which is formed of an LFP positive electrode material using iron phosphate in place of cobalt. The LFP battery uses iron phosphate, which is less expensive than cobalt, thereby reducing the cost of raw materials used for battery manufacturing, and has an olivine structure, which is formed in a hexahedral shape, among various types of positive electrode material structures, thereby being stable. Accordingly, the LFP battery has advantages in that a possibility of accidents caused by overcharging or overdischarging is relatively low, and degradation of battery cells is reduced, thereby resulting in a relatively long battery lifespan.

A battery pack including a plurality of battery cells may include a battery management system (BMS) configured to manage the plurality of battery cells, for example, by monitoring voltage, current, and temperature of the plurality of battery cells included in the battery pack.

It is desired to develop a battery model in order to implement an algorithm that determines battery parameters such as a state of charge (SOC), a state of health (SOH), and the like, which are applied to the BMS. However, in a comparative equivalent circuit model (ECM) method used for ternary batteries which do not implement aspects of the present disclosure, a unique characteristic of LFP batteries, in which internal resistance varies depending on a charging or discharging path, cannot be reflected in any way. Accordingly, the conventional ECM method is problematic in that errors in the battery model increase, and as a result, errors in the SOC and SOH also increase.

The information disclosed in this Background section is for enhancement of understanding of the background of the present disclosure, and therefore, it may contain information that does not constitute related (or prior) art.

## SUMMARY

Embodiments of the present disclosure are directed to providing an apparatus and a method of generating a lithium iron phosphate ($LiFePO_4$, LFP) battery model, which record a state of lithium (Li) in a positive electrode active material of an LFP battery according to charging or discharging of the LFP battery, and generate a battery model of the LFP battery based on the recorded state of the Li in the positive electrode active material.

However, the technical problem to be solved by the present disclosure is not limited to problems described herein, and other problems not mentioned herein, and aspects and features of the present disclosure that would address such problems, will be clearly understood by those skilled in the art from the description of the present disclosure herein.

An apparatus for generating a lithium iron phosphate ($LiFePO_4$, LFP) battery model according to embodiments of the present disclosure may include: a lithium state recorder configured to record a state of lithium (Li) in a positive electrode active material of an LFP battery according to charging or discharging of the LFP battery; and a battery model generator configured to generate a battery model of the LFP battery based on the recorded state of the Li in the positive electrode active material. The battery model generator may generate the battery model by modeling the LFP battery through adding an additional voltage increment corresponding to a charging or discharging path of the LFP battery to an open circuit voltage (OCV), in consideration of the state of the Li in the positive electrode active material.

In embodiments, the Li state recorder may record a distribution state of the Li from a peripheral portion to a center in the positive electrode active material of the LFP battery, the distribution state varying depending on the charging or discharging of the LFP battery.

In embodiments, the battery model generator may generate the battery model of the LFP battery in a form in which the additional voltage increment corresponding to the charging or discharging path of the LFP battery is included in an equivalent circuit model (ECM).

In embodiments, the battery model generator may determine parameters of the ECM in a pattern with a least path-dependent effect of the positive electrode active material for each state of charge (SOC) and each temperature condition at a set charging and discharging rate (c-rate).

In embodiments, the battery model generator may store a difference between a voltage in a pattern with a greatest path-dependent effect of the positive electrode active material and a voltage in the pattern with the least path-dependent effect in a table for each SOC and each temperature condition at the set c-rate.

In embodiments, the battery model generator may determine the additional voltage increment corresponding to the charging or discharging path of the LFP battery by multiplying the difference between the voltage in the pattern with the greatest path-dependent effect of the positive electrode active material and the voltage in the pattern with the least path-dependent effect for each SOC and each temperature condition at the set C-rate by a correction value that reflects the state of the Li in the positive electrode active material.

In embodiments, when the correction value reflecting the state of the Li in the positive electrode active material is denoted as K_rate(soc), and the difference between the voltage in the pattern with the greatest path-dependent effect of the positive electrode active material and the voltage in the pattern with the least path-dependent effect for each SOC and each temperature condition at the set C-rate is denoted as V_path_effect_max(soc) - V_path_effect_min(soc), V_path indicating the additional voltage increment corresponding to the charging or discharging path of the LFP battery may be determined by a following equation:

$$V_path(soc) = K_rate(soc) \times \{V_path_effect_max(soc) - V_path_effect_min(soc)\}.$$

In embodiments, the battery model generator may generate the battery model of the LFP battery by classifying, when charging the LFP battery, the state of the Li distribution into a first circumstance in which the Li is not distributed in the peripheral portion of the positive electrode active material of the LFP battery, and a second circumstance in which the Li is distributed in the peripheral portion of the positive electrode active material of the LFP battery.

In embodiments, in the first circumstance, K_rate(soc) that is the correction value reflecting the state of the Li in the positive electrode active material may be 1.

In embodiments, in the second circumstance, when a Li distribution start point closest to the peripheral portion in the positive electrode active material of the LFP battery according to the SOC is denoted as K_a(soc), and a Li distribution end point closest to the peripheral portion in the positive electrode active material of the LFP battery at a moment when charging starts after a discharged state or a rest state following discharging is denoted as K_b_captured, K_rate(soc) that is the correction value reflecting the state of the Li in the positive electrode active material may be determined by a following equation:

$$K_rate(soc) = (K_a(soc)/K_b_captured).$$

In embodiments, the battery model generator may generate the battery model of the LFP battery by classifying, when discharging the LFP battery, the state of the Li distribution into a third circumstance in which the Li is not distributed in a peripheral portion of the positive electrode active material of the LFP battery, and a fourth circumstance in which the Li is distributed in the peripheral portion of the positive electrode active material of the LFP battery.

In embodiments, in the fourth circumstance, K_rate(soc) that is the correction value reflecting the state of the Li in the positive electrode active material may be 1.

In embodiments, in the third circumstance, when a Li distribution end point closest to the peripheral portion in the positive electrode active material of the LFP battery according to the SOC is denoted as K_b(soc), and a Li distribution start point closest to the peripheral portion in the positive electrode active material of the LFP battery at a moment when discharging starts after a charged state or a rest state following charging is denoted as K_a_captured, K_rate(soc) that is the correction value reflecting the state of the Li in the positive electrode active material is determined by a following equation:

$$K_rate(soc) = (K_b(soc)/K_a_captured).$$

.

A method of generating a lithium iron phosphate ($LiFePO_4$, LFP) battery model according to embodiments of the present disclosure may include: a lithium state recording operation of recording, by a lithium state recorder, a state of lithium (Li) in a positive electrode active material of an LFP battery according to charging or discharging of the LFP battery; and a battery model generation operation of generating, by a battery model generator, a battery model of the LFP battery based on the recorded state of the Li in the positive electrode active material. The battery model generation operation may include generating the battery model by modeling the LFP battery through adding an additional voltage increment corresponding to a charging or discharging path of the LFP battery to an open circuit voltage (OCV), in consideration of the state of the Li in the positive electrode active material.

In embodiments, the Li state recording operation may include recording a distribution state of the Li from a peripheral portion to a center in the positive electrode active material of the LFP battery, the distribution state varying depending on the charging or discharging of the LFP battery.

In embodiments, the battery model generation operation may include generating the battery model of the LFP battery in a form in which the additional voltage increment corresponding to the charging or discharging path of the LFP battery is included in an equivalent circuit model (ECM).

In embodiments, the battery model generation operation may further include determining parameters of the ECM in a pattern with a least path-dependent effect of the positive electrode active material for each state of charge (SOC) and each temperature condition at a set charging and discharging rate (c-rate).

In embodiments, the battery model generation operation may further include storing a difference between a voltage in a pattern with a greatest path-dependent effect of the positive electrode active material and a voltage in the pattern with the least path-dependent effect in a table for each SOC and each temperature condition at the set c-rate.

In embodiments, the battery model generation operation may further include determining the additional voltage increment corresponding to the charging or discharging path of the LFP battery by multiplying the difference between the voltage in the pattern with the greatest path-dependent effect of the positive electrode active material and the voltage in the pattern with the least path-dependent effect for each SOC and each temperature condition at the set C-rate by a correction value that reflects the state of the Li in the positive electrode active material.

In embodiments, the battery model generation operation may further include determining V_path indicating the additional voltage increment corresponding to the charging or discharging path of the LFP battery by a following equation, when the correction value reflecting the state of the Li in the positive electrode active material is denoted as K_rate(soc), and the difference between the voltage in the pattern with the greatest path-dependent effect of the positive electrode active material and the voltage in the pattern with the least path-dependent effect for each SOC and each temperature condition at the set C-rate is denoted as V_path_effect_max(soc) - V_path_effect_min(soc):

$$V_path(soc) = K_rate(soc) \times \{V_path_effect_max(soc)-V_path_effect_min(soc)\}.$$

According to embodiments of the present disclosure, a state of lithium (Li) in a positive electrode active material of a lithium iron phosphate ($LiFePO_4$, LFP) battery according to charging or discharging of the LFP battery is recorded, and a battery model of the LFP battery is generated based on the recorded state of Li in the positive electrode active material. Accordingly, it is possible to record the state of Li in the positive electrode active material that changes depending on the history of a previous charging or discharging path, define variation in internal resistance depending on a current internal state of the positive electrode that reflects the history of the previous charging or discharging path, and ultimately apply the defined variation to the battery model.

According to embodiments of the present disclosure, a battery model that reflects the internal state of the positive electrode active material that varies depending on the history of the previous charging or discharging path is generated. Hence, errors in the battery model may be reduced, and the accuracy may be improved, thereby reducing errors in a state of charge (SOC) and a state of health (SOH) of the battery, which are calculated by a battery management system (BMS) .

However, aspects and features of the present disclosure are not limited to those described herein, and other aspects and features not mentioned will be clearly understood by a person skilled in the art from the detailed description, described herein.

At least some of the above and other features of the invention are set out in the claims.

## BRIEF DESCRIPTION OF THE DRAWINGS

The following drawings attached to this specification illustrate preferred embodiments of the present disclosure, and help to further understand the technical spirit of the present disclosure along with the aforementioned contents of the disclosure. Accordingly, the present disclosure should not be construed as being limited to only contents described in such

drawings:

FIG. 1 is a schematic view illustrating a cylindrical lithium secondary battery according to embodiments;
FIG. 2 is a schematic diagram illustrating a prismatic lithium secondary battery according to embodiments;
FIGS. 3 and 4 are schematic diagrams illustrating a pouch-type lithium secondary battery according to embodiments;
FIG. 5 illustrates a battery model implemented by a comparative equivalent circuit model (ECM) method;
FIG. 6 is a diagram illustrating an example of a resistance value varying depending on a charging path of a lithium iron phosphate (LFP) battery;
FIG. 7 is a diagram schematically illustrating an apparatus for generating an LFP battery model according to embodiments of the present disclosure;
FIG. 8 is a diagram for explaining a method by which a lithium state recorder of the LFP battery model generation apparatus according to embodiments of the present disclosure records a state of lithium in a positive electrode active material of the LFP battery;
FIG. 9 illustrates an example in which the lithium state recorder of the LFP battery model generation apparatus according to embodiments of the present disclosure records the state of lithium in the positive electrode active material of the LFP battery;
FIG. 10 is a diagram for explaining examples in which the lithium state recorder of the LFP battery model generation apparatus according to embodiments of the present disclosure records the state of lithium in the positive electrode active material of the LFP battery during charging of the LFP battery;
FIG. 11 is a diagram for explaining examples in which the lithium state recorder of the LFP battery model generation apparatus according to embodiments of the present disclosure records the state of lithium in the positive electrode active material of the LFP battery during discharging of the LFP battery;
FIG. 12 is a diagram illustrating an example of a battery model generated by a battery model generator of the LFP battery model generation apparatus according to embodiments of the present disclosure;
FIG. 13 is a diagram for explaining examples in which the battery model generator of the LFP battery model generation apparatus according to embodiments of the present disclosure generates a battery model based on a state of lithium in the positive electrode active material of the LFP battery, the state being recorded by the lithium state recorder during charging of the LFP battery;
FIG. 14 is a diagram for explaining examples in which the battery model generator of the LFP battery model generation apparatus according to embodiments of the present disclosure generates a battery model based on a state of lithium in the positive electrode active material of the LFP battery, the state being recorded by the lithium state recorder during discharging of the LFP battery; and
FIG. 15 is a flowchart for explaining a method of generating an LFP battery model according to embodiments of the present disclosure.

## DETAILED DESCRIPTION

Example embodiments of the present disclosure will be described herein in detail with reference to the accompanying drawings. Since the embodiments described in this specification and the configurations illustrated in the drawings are only an example of the present disclosure and they do not cover all the technical ideas of the present disclosure, it should be understood that various changes and modifications may be made at the time of filing this application.

It will be further understood that the terms "comprises/includes" and/or "comprising/including" when used herein, specify the presence of stated features, integers, steps, operations, elements, components, and/or groups thereof, but do not preclude the presence or addition of one or more other features, integers, steps, operations, elements, components, and/or groups thereof.

In order to facilitate understanding of the present disclosure, the accompanying drawings are not drawn to scale and the dimensions of some components may be exaggerated. It should be noted that the same reference numerals are designated to the same components in different embodiments.

Reference to two compared elements, features, etc. as being "the same" means that they are "substantially the same". Therefore, the phrase "substantially the same" may include a deviation that is considered low in the art, for example, a deviation of 5% or less. The uniformity of any parameter in a given region may mean that it is uniform from an average perspective.

Although the terms such as "first" and/or "second" are used to describe various components, these components are not limited by these terms, of course. These terms are only used to distinguish one component from another component. Thus, unless specifically stated to the contrary, a first component may be termed a second component without departing from the teachings of example embodiments.

Throughout the specification, unless otherwise stated, each element may be singular or plural.

Arrangement of any component "above (or below)" or "on (or under)" a component may mean that any component is disposed in contact with the upper (or lower) surface of the component, as well as that other components may be interposed between the element and any element disposed on (or under) the element.

It will be understood that, when a component is referred to as being "connected", "coupled", or "joined" to another component, not only can it be directly "connected", "coupled", or "joined" to the other element, but also can it be indirectly "connected", "coupled", or "joined" to the other element with other elements interposed therebetween.

As used herein, the term "and/or" includes any and all combinations of one or more of the associate listed items. The use of "may" when describing embodiments of the present disclosure relates to "one or more embodiments of the present disclosure". Expressions such as "at least one" and "one or more" preceding a list of elements modify the entire list of elements and do not modify the individual elements in the list.

Throughout the specification, when "A and/or B" is stated, it means A, B, or A and B, unless otherwise stated. In addition, when "C to D" is stated, it means C or more and D or less, unless specifically stated to the contrary.

When the phrase such as "at least one of A, B, and C", "at least one of A, B, or C", "at least one selected from the group of A, B, and C", or "at least one selected from among A, B, and C" is used to designate a list of elements A, B, and C, the phrase may refer to any and all suitable combinations.

The term "use" may be considered synonymous with the term "utilize". As used herein, the terms "substantially," "about," and similar terms are used as terms of approximation rather than as terms of degree, and are intended to account for inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, component, region, layer, or section discussed herein may be termed a second element, component, region, layer, or section without departing from the teachings of example embodiments.

For ease of explanation in describing the relationship of one element or feature to another element(s) or feature(s) as illustrated in the drawings, spatially relative terms such as "beneath", "below", "lower", "above", and "upper" may be used herein. It will be understood that spatially relative positions are intended to encompass different directions of the device in use or operation in addition to the direction depicted in the drawings. For example, if the device in the drawings is turned over, any element described as being "below" or "beneath" another element would then be oriented "above" or "over" another element. Therefore, the term "below" may encompass both upward and downward directions.

The terminology used herein is for the purpose of describing embodiments of the present disclosure and is not intended to limit the present disclosure.

The type of secondary battery includes a coin type, a cylindrical type, a prismatic type, and a pouch type. Prior to a description of embodiments of the present disclosure, first, cylindrical and prismatic secondary batteries are roughly described because the present disclosure may be basically applied to the cylindrical and prismatic secondary batteries.

FIGS. 1 to 4 are schematic diagrams illustrating lithium secondary batteries according to implementation examples. FIG. 1 may illustrate a cylindrical lithium secondary battery. FIG. 2 may illustrate a prismatic type secondary battery. FIGS. 3 and 4 may illustrate a pouch type secondary battery. Referring to FIG. 1 to 4, a lithium secondary battery 1 may include an electrode assembly 40 in which a separator 30 has been interposed between a first electrode plate 10 and a second electrode plate 20 and a case 50 in which the electrode assembly 40 has been embedded. The first electrode plate 10, the second electrode plate 20, and the separator 30 may be impregnated in an electrolyte (not illustrated). As illustrated in FIG. 1, the lithium secondary battery 1 may include a sealing member 60 that seals the case 50. Furthermore, in FIG. 2, the lithium secondary battery 1 may include a first electrode lead tab 11, a first electrode terminal 12, a second electrode lead tab 21, and a second electrode terminal 22. As illustrated in FIGS. 3 and 4, the lithium secondary battery 1 may include an electrode tab 70 that plays a role as an electrical passage for inducing a current formed in the electrode assembly 40 toward the outside, that is, a first electrode tab 71 and a second electrode tab 72.

The electrode assembly 40 may be formed by winding or stacking a stack body including the first electrode plate 10, the second electrode plate 20, and the separator 30 each of which is formed in a plate or film shape. In the circumstance of the winding stack body, the winding axis of the electrode assembly 40 may be parallel to the length direction of the case. Furthermore, the electrode assembly 40 may be the stack type not the winding type, but a shape of the electrode assembly 40 is not limited in embodiments of the present disclosure. The first electrode plate 10 of the electrode assembly 40 may play a role as a positive electrode, and the second electrode plate 20 thereof may play a role as a negative electrode, and vice versa.

The first electrode plate 10 may be formed by applying a first electrode active material, such as graphite or carbon, to a first electrode collector plate formed of metal foil, such as copper, a copper alloy, nickel, or a nickel alloy, and may include a first electrode tab (or a first uncoated part), that is, an area to which the first electrode active material has not been applied.

The second electrode plate 20 may be formed by applying a second electrode active material, such as transition

metal oxide, to a material formed of metal foil, such as aluminum or an aluminum alloy, and may include a second electrode tab (or a second uncoated part), that is, an area to which the second electrode active material has not been applied.

The separator 30 may function to prevent a short-circuit between the first electrode plate 10 and the second electrode plate 20 while permitting a movement of lithium ions. The separator 30 may be composed of a polyethylene film, a polypropylene film, or a polyethylene-polypropylene film, for example.

FIG. 5 illustrates a battery model implemented by an equivalent circuit model (ECM) method according to a comparative example which does not implement aspects of the present disclosure.

Referring to FIG. 5, a battery model implemented by the comparative ECM method may be represented by a series resistor $R_s$ for simulating a voltage drop in connection of a load and a voltage rise during charging, and a parallel resistor $R_p$ and a parallel capacitor $C_p$ for simulating a dynamic voltage response of a battery immediately after the voltage drop. In a comparative ternary battery, there is no path dependency, and thus resistance and capacitor values in a model do not need to include a previous charging or discharging history. Accordingly, a battery may be sufficiently simulated using a battery model based on the comparative ECM method.

However, an LFP battery may have a unique characteristic in that an internal resistance value varies depending on a charging or discharging path of the battery. For example, in the circumstance where a state of charge (SOC) of the LFP battery is decreased to 50% by discharging from 100%, and in another circumstance where the SOC is increased to 50% by charging from 0%, the LFP battery in both circumstances may have the same SOC value of 50%. However, since the charging and discharging paths to reach the SOC of 50% are different, a distribution of lithium (Li) ions in a positive electrode active material may become different, and the difference in the distribution may cause internal resistance values in the two circumstances to vary, resulting in different internal resistance values.

Accordingly, in the circumstance of the LFP battery, if a battery model implemented by the comparative ECM method is used, there is a problem in that, when parameters of the series resistor $R_s$, the parallel resistor $R_p$, and the parallel capacitor $C_p$ are set based on a specific charging or discharging path, all differences in internal resistance values caused by other charging or discharging paths appear as errors.

FIG. 6 is a diagram illustrating an example of the resistance value varying depending on the charging path of the LFP battery.

Referring to FIG. 6, a voltage variation graph over time is illustrated for the circumstance where the SOC increases from 40% to 60%, the circumstance where the SOC decreases from 45% to 40% and then increases to 60%, and the circumstance where the SOC decreases from 50% to 40% and then increases to 60%.

As illustrated in FIG. 6, in the circumstance where the SOC increases from 40% to 60%, the voltage increases with the highest gradient. In the circumstance where the SOC decreases from 45% to 40% and then increases to 60%, the gradient of voltage rise is slightly smaller than that in the former circumstance. In the circumstance where the SOC decreases from 50% to 40% and then increases to 60%, the voltage increases with the lowest gradient.

The reason for the foregoing is that differences in internal resistance values occur depending on a charging or discharging path of the LFP battery, and such differences result in variations in the voltage rise graph. Accordingly, the battery model implemented by the comparative ECM method of FIG. 5 is problematic in that even if parameters are set based on a graph corresponding to any charging or discharging path, errors occur in all other charging or discharging paths.

Accordingly, in the circumstance where an ECM model is intended to be applied to an LFP battery, parameters need to be supplemented so that the charging or discharging path of the LFP battery is reflected in the parameters. In accordance with an apparatus and a method of generating an LFP battery model according to embodiments of the present disclosure, internal resistance values that vary depending on charging and discharging paths may all be reflected in the battery model. Therefore, a battery model can be generated regardless of which charging or discharging path is followed among the three graphs in FIG. 6. As a result, errors in the battery model may be reduced, thereby improving accuracy.

FIG. 7 is a diagram schematically illustrating an apparatus for generating an LFP battery model according to embodiments of the present disclosure.

Referring to FIG. 7, the LFP battery model generation apparatus 100 according to embodiments of the present disclosure may include a lithium state recorder 110 and a battery model generator 120. The LFP battery model generation apparatus 100 according to embodiments of the present disclosure may be included in a battery management system (BMS), and may generate a battery model of an LFP battery 1.

The lithium state recorder 110 may record a state of lithium in a positive electrode active material of the LFP battery 1 according to charging or discharging of the LFP battery 1.

The battery model generator 120 may generate the battery model of the LFP battery 1 based on the recorded state of lithium in the positive electrode active material. In embodiments, the battery model generator 120 may generate the battery model by modeling the LFP battery through adding an additional voltage increment corresponding to a charging or discharging path of the LFP battery, to an open circuit voltage (OCV).

Hereinafter, with reference to the drawings, examples of specific methods will be described, in which the lithium state recorder 110 records the state of lithium in the positive electrode active material of the LFP battery 1, and the battery

model generator 120 generates a battery model of the LFP battery 1 based on the recorded state of lithium in the positive electrode active material.

FIG. 8 is a diagram for explaining a method by which the lithium state recorder of the LFP battery model generation apparatus according to embodiments of the present disclosure records the state of lithium in the positive electrode active material of the LFP battery.

Referring to FIG. 8, the positive electrode active material of the LFP battery is illustrated. The left portion in the drawing illustrates the positive electrode active material in the circumstance where charging is performed from a fully discharged state, that is, an SOC of 0%, to an SOC of 50%. The right portion in the drawing illustrates the positive electrode active material in the circumstance where discharging is performed from a fully charged state, that is, an SOC of 100%, to an SOC of 50%.

As charging or discharging progresses, the positive electrode active material repeatedly transitions between a $LiFePO_4$ (LFP) state and a $FePO_4$ (FP) state, which may be represented by the following chemical formula.

[Chemical Formula 1]

$$\underset{\text{(LFP)}}{Li_xFePO_4} \leftrightarrow \underset{\text{(FP)}}{Li_yFePO_4} + (x-y)\,Li^+ + (x-y)\,e^-$$

Due to a chemical reaction as represented by the above chemical formula, during charging from the fully discharged state as shown on the left portion of FIG. 8, Li+ ions exit toward a negative electrode starting from a peripheral portion of the positive electrode active material. Here, a boundary between an outer FP region and an inner LFP region moves from the peripheral portion toward the center.

In addition, during discharging from the fully charged state as shown on the right portion of FIG. 8, Li+ ions are pushed into a positive electrode starting from a peripheral portion of the positive electrode active material. In this circumstance, a boundary between an outer LFP region and an inner FP region moves from the peripheral portion toward the center.

The state of lithium in the positive electrode active material, that is, a change in the distribution of lithium, may be represented as a one-dimensional bar graph illustrating a region from the peripheral portion to the center of the positive electrode active material. For example, the circumstance of discharging from the fully charged state shown on the right portion of FIG. 8 will be described with reference to a bar graph in the lower portion of FIG. 8. When lithium flows in from the peripheral portion, the boundary between the outer LFP region and the inner FP region moves from the peripheral portion toward the center. As a result, a left region closer to the peripheral portion may become a rich phase in which lithium is sufficient, and a right region closer to the center may become a poor phase in which lithium is nearly absent.

Here, the description "lithium is distributed in the peripheral portion" may mean a state in which, when a positive electrode active material particle is modeled, lithium ions accumulate from a surface of the positive electrode active material particle, thus forming a layer adjacent to the surface of the particle. The aforementioned layer allows lithium adjacent to the surface of the particle to easily exit during charging, and makes it difficult for lithium to enter during discharging due to the lithium adjacent to the surface of the particle.

FIG. 9 illustrates an example in which the lithium state recorder of the LFP battery model generation apparatus according to embodiments of the present disclosure records the state of lithium in the positive electrode active material of the LFP battery.

Referring to FIG. 9, an example of a bar graph is illustrated, in which the lithium state recorder of the LFP battery model generation apparatus according to embodiments of the present disclosure records the state of lithium in the positive electrode active material of the LFP battery by the method described in FIG. 8.

As described herein with reference to FIG. 8, during charging from the fully discharged state, when Li+ ions exit toward the negative electrode starting from the peripheral portion of the positive electrode active material, the boundary between the outer FP region and the inner LFP region moves from the peripheral portion toward the center. During discharging from the fully charged state, when Li+ ions are pushed into the positive electrode starting from the peripheral portion of the positive electrode active material, the boundary between the outer LFP region and the inner FP region moves from the peripheral portion toward the center.

The foregoing charging and discharging processes may be recorded through the SOC of the battery. In this circumstance, a starting position of lithium ions may be expressed as a point start P_S, and an ending position of lithium ions may be expressed as a point end P_E. According to such charging and discharging history, an internal layer may be formed, and P_S and P_E may be represented as multiple arrays in order to express such layer information, as illustrated in FIG. 9.

The internal state may be simulated only in a region (corresponding to an SOC range of approximately 5% to

95%) where a rich (beta) phase and a poor (alpha) phase coexist in the positive electrode active material and the voltage remains flat. However, for convenience, the same simulation method may be applied to other regions, and thereafter, when applied to the model, the corresponding algorithm may be reflected only in the region of the positive electrode active material where the voltage remains flat.

FIG. 10 is a diagram for explaining examples in which the lithium state recorder of the LFP battery model generation apparatus according to embodiments of the present disclosure records the state of lithium in the positive electrode active material of the LFP battery during charging of the LFP battery.

Referring to FIG. 10, a state of lithium in a positive electrode active material of the LFP battery during charging is illustrated. During charging of the LFP battery, Li+ ions exit through the peripheral portion of the positive electrode active material and move toward the negative electrode, and thus a boundary between the FP region and the LFP region shifts toward the center.

In FIG. 10, in the circumstance of (a), as shown on the right portion in the drawing, charging may be performed from an SOC of 30% to 40%, and the peripheral portion may be in a poor phase. Accordingly, when charging is performed up to an SOC of 100%, the Li+ ions located inside are required to pass through the portion in the poor phase to move outward, resulting in high internal resistance.

In the circumstance of (c), as shown on the right portion in the drawing, discharging may be performed from the SOC of 100% to 40%, and a rich phase may remain in the peripheral portion. Accordingly, when charging is performed up to an SOC of 50%, the Li+ ions may directly move outward from the peripheral portion, resulting in low internal resistance.

In the circumstance of (b), as shown on the right portion in the drawing, discharging may be performed from the SOC of 50% to 40%, and although a rich phase remains in the peripheral portion, the amount thereof may be smaller than that in the circumstance of (c). Accordingly, when charging is performed up to the SOC of 50%, the internal resistance may gradually increase until the Li+ ions are completely extracted from a most peripheral portion in the rich phase. Here, the internal resistance may be related to the thickness of the most peripheral portion in the rich phase.

FIG. 11 is a diagram for explaining examples in which the lithium state recorder of the LFP battery model generation apparatus according to embodiments of the present disclosure records the state of lithium in the positive electrode active material of the LFP battery during discharging of the LFP battery.

Referring to FIG. 11, the state of lithium in the positive electrode active material of the LFP battery during discharging of the LFP battery is illustrated. During discharging of the LFP battery, Li+ ions enter through the peripheral portion of the positive electrode active material from the negative electrode; therefore, the boundary between the LFP region and the FP region moves toward the center.

In FIG. 11, in the circumstance of (a), as shown on the right portion in the drawing, discharging may be performed from an SOC of 60% to 50%, and the peripheral portion may be in a rich phase. Accordingly, when discharging is performed down to an SOC of 0%, the Li+ ions located in the peripheral portion are required to pass through the portion in the rich phase to enter, resulting in high internal resistance.

In the circumstance of (c), as illustrated on the right portion in the drawing, charging may be performed from the SOC of 0% to 50%, and a poor phase may be present in the peripheral portion. Accordingly, when discharging is performed down to an SOC of 40%, Li+ ions may directly enter from the peripheral portion and directly settle in place, resulting in low internal resistance.

In the circumstance of (b), as illustrated on the right portion of the drawing, charging may be performed from the SOC of 40% to 50%, and although a poor phase remains in the peripheral portion, the amount thereof may be smaller than that in the circumstance of (c). Accordingly, when discharging is performed down to the SOC of 40%, internal resistance may gradually increase until Li+ ions fully occupy the most peripheral portion in the poor phase. Here, the internal resistance may be related to the thickness of the most peripheral portion in the poor phase.

As described herein, the lithium state recorder 110 of the LFP battery model generation apparatus 100 according to embodiments of the present disclosure may record the state of lithium in the positive electrode active material of the LFP battery 1 by the method described with reference to FIGS. 8 to 11.

FIG. 12 is a diagram illustrating an example of a battery model generated by a battery model generator of the LFP battery model generation apparatus according to embodiments of the present disclosure.

Referring to FIG. 12, the battery model generator 110 of the LFP battery model generation apparatus 100 according to embodiments of the present disclosure may generate a battery model of the LFP battery in a form in which an additional voltage increment (V_path) corresponding to a charging or discharging path of the LFP battery is included in an equivalent circuit model ECM. In other words, a battery model may be generated by maintaining a series resistor $R_s$, a parallel resistor $R_p$, a parallel capacitor $C_p$, and an open circuit voltage $V_{OCV}$ in a battery model generated by the comparative ECM method, and adding an additional voltage increment V_path corresponding to a charging or discharging path of the LFP battery to the battery model.

**In** this circumstance, determined by the battery model generator 110, the additional voltage increment V_path corresponding to the charging or discharging path of the LFP battery may vary depending on whether charging or discharging is performed. Hereinafter, a method of determining the additional voltage increment V_path corresponding to

the charging or discharging path of the LFP battery will be described.

**In** the battery model generator 110 of the LFP battery model generation apparatus 100 according to embodiments of the present disclosure, conventional ECM parameters (e.g. according to the comparative example described elsewhere herein) may be set using a pattern with a least path-dependent effect of the positive electrode active material, and an additional voltage increment corresponding to the charging or discharging path of the LFP battery may be added to the open circuit voltage $V_{OCV}$. As a result, a voltage error of the model may be reduced. Accordingly, an effect value corresponding to the charging or discharging path may be more easily reflected in applications in which a commonly used current band is relatively constant. However, if the operation deviates from a commonly used charging and discharging rate (c-rate) range, errors of the battery model may increase. In this case, the error of the battery model may be reduced by increasing the number of commonly used crates and expanding a corresponding table for each c-rate.

A method of determining the additional voltage increment V_path corresponding to the charging or discharging path of the LFP battery by the battery model generator 110 of the LFP battery model generation apparatus 100 according to embodiments of the present disclosure, will be described in detail. First, the battery model generator 110 determines parameters of the ECM based on the pattern with the least path-dependent effect of the positive electrode active material, at a given c-rate, for each SOC and each temperature condition. Here, the given c-rate may be set to a default value as a commonly used c-rate or may be set by a user. Parameters of the ECM may refer to values of a series resistor $R_s$, a parallel resistor $R_p$, a parallel capacitor $C_p$, and an open circuit voltage $V_{OCV}$ in the battery model generated by the comparative ECM method. Furthermore, the pattern with the least path-dependent effect of the positive electrode active material may refer to a state where, as described in (c) of FIG. 10, in experiments conducted for each SOC, discharging is always performed from the SOC of 100%, so that, when setting the SOC, the peripheral portion of the positive electrode active material becomes a rich phase, allowing lithium ions to be directly extracted and thereby resulting in the lowest internal resistance. For example, when determining parameters for the case of charging from an SOC of 30%, the parameters may be determined by first performing discharging from the SOC of 100% to the SOC of 30% and then performing the experiment.

After the parameters of the ECM are determined, the battery model generator 110 may store a difference between a voltage in a pattern with a greatest path-dependent effect of the positive electrode active material and a voltage in the pattern with the least path-dependent effect in a table for each SOC and each temperature condition at a given c-rate. For example, in the case of charging, the pattern with the greatest path-dependent effect of the positive electrode active material may refer to a state where, as described in (a) of FIG. 10, in experiments conducted for each SOC, charging is always performed from the SOC of 0% so that, when setting the SOC, the peripheral portion of the positive electrode active material becomes a poor phase, resulting in the highest internal resistance because lithium ions are required to be extracted from an inner portion in a rich phase. For instance, when determining parameters for the case of charging from an SOC of 30%, the parameters may be determined by first performing charging from the SOC of 0% to the SOC of 30%, and then conducting the experiment. Conversely, in the case of charging, the pattern with the least path-dependent effect of the positive electrode active material may require the SOC to be set through a previous discharging process, as described in (c) of FIG. 10. The pattern with the least path-dependent effect of the positive electrode active material may refer to a state where, in experiments conducted for each SOC, discharging is always performed from the SOC of 100% so that, when setting the SOC, the peripheral portion of the positive electrode active material becomes a rich phase, resulting in the lowest internal resistance because lithium ions can be directly extracted from the peripheral portion in the rich phase. For instance, when determining parameters for the case of charging from the SOC of 30%, the parameters may be determined by first performing discharging from the SOC of 100% to the SOC of 30%, and then conducting the experiment. In the case of discharging, the pattern with the greatest path-dependent effect of the positive electrode active material may require the SOC to be set through a previous discharging process. The pattern with the greatest path-dependent effect of the positive electrode active material may refer to a state where in experiments conducted for each SOC, discharging is always performed from the SOC of 100% so that, when setting the SOC, the peripheral portion of the positive electrode active material becomes a rich phase, resulting in the highest internal resistance because lithium ions are required to bypass the peripheral portion in the rich phase and enter the central portion. For instance, when determining parameters for the case of charging from the SOC of 30%, the parameters may be determined by first performing discharging from the SOC of 100% to the SOC of 30%, and then conducting the experiment. Conversely, in the case of discharging, the pattern with the least path-dependent effect of the positive electrode active material may require the SOC to be set through a previous charging process. The pattern with the least path-dependent effect of the positive electrode active material may refer to a state where, in experiments conducted for each SOC, charging is always performed from the SOC of 0% so that, when setting the SOC, the peripheral portion of the positive electrode active material becomes a poor phase, resulting in the lowest internal resistance because lithium ions can directly enter the peripheral portion in the poor phase. For instance, when determining parameters for the case of discharging from the SOC of 30%, the parameters may be determined by first performing charging from the SOC of 0% to the SOC of 30%, and then conducting the experiment.

After storing a difference between a voltage in the pattern with the greatest path-dependent effect of the positive electrode active material and a voltage in the pattern with the least path-dependent effect in the table for each SOC and

each temperature condition at a given c-rate, the battery model generator 110 may determine an additional voltage increment corresponding to a charging or discharging path of the LFP battery by multiplying the difference between the voltage in the pattern with the greatest path-dependent effect of the positive electrode active material and the voltage in the pattern with the least path-dependent effect for each SOC and each temperature condition at the given c-rate by a correction value that reflects the state of lithium in the positive electrode active material.

In embodiments, assuming that the correction value reflecting the state of lithium in the positive electrode active material is denoted as K_rate(soc), and the difference between the voltage in the pattern with the greatest path-dependent effect of the positive electrode active material and the voltage in the pattern with the least path-dependent effect, for each SOC and each temperature condition at the given c-rate, is denoted as V_path_effect_max(soc) - V_path_effect_min(soc), the additional voltage increment V_path corresponding to the charging or discharging path of the LFP battery may be determined by the following equation.

[Equation 1] V_path(SOC) = K_rate(soc) × {V_path_effect_max(soc) - V_path_effect_min(soc)} [Equation 1]

Hereinafter, a method of determining the correction value K_rate(soc), which reflects the state of lithium in the positive electrode active material, will be described.

FIG. 13 is a diagram for explaining examples in which the battery model generator of the LFP battery model generation apparatus according to embodiments of the present disclosure generates a battery model based on a state of lithium in the positive electrode active material of the LFP battery, the state being recorded by the lithium state recorder during charging of the LFP battery.

Referring to FIG. 13, the battery model generator 110 may generate a battery model of the LFP battery 1 by classifying, when charging the LFP battery 1, the state of the lithium distribution into a first case in which lithium ions are not distributed in the peripheral portion of the positive electrode active material of the LFP battery 1, and a second case in which lithium ions are distributed in the peripheral portion of the positive electrode active material of the LFP battery 1.

The first case may refer to the case in which lithium ions have been extracted during a previous charging process, resulting in the absence of lithium ions in the peripheral portion of the positive electrode active material. The second case may refer to the case in which lithium ions have entered during a previous discharging process, resulting in lithium ions being accumulated in the peripheral portion of the positive electrode active material. The aforementioned lithium distribution may be maintained regardless of whether a rest period exists between a previous state and a current state.

As shown in FIG. 13, in the first circumstance, when charging is performed from an SOC of 40% to an SOC of 50% through an SOC of 45%, starting from a state in which lithium ions are absent in the peripheral portion of the positive electrode active material, lithium ions in an inner portion are required to pass through a portion in the poor phase to exit, resulting in high internal resistance. In the first circumstance, the correction value K_rate(soc), which reflects the state of lithium in the positive electrode active material, may be set to 1.

As shown in FIG. 13, in the second circumstance, when charging is performed from the SOC of 40% to the SOC of 50% through the SOC of 45%, starting from a state in which lithium ions are accumulated in the peripheral portion of the positive electrode active material, the lithium ions in the peripheral portion may be directly extracted from the peripheral portion. In this circumstance, internal resistance may gradually increase until the lithium ions are completely extracted from the most peripheral portion in the rich phase. In the second circumstance, assuming that a lithium distribution start point closest to the peripheral portion of the positive electrode active material of the LFP battery according to the SOC is denoted as K_a(soc), and a lithium distribution end point closest to the peripheral portion of the positive electrode active material of the LFP battery at a moment when charging starts after a discharged state or a rest state following discharging is denoted as K_b_captured, the correction value K_rate(soc), which reflects the state of lithium in the positive electrode active material, may be determined by the following equation. Here, K_a(soc) may continuously vary depending on the amount of lithium ions extracted from the peripheral portion, during charging, until discharging is performed again or a rest state occurs. The value of K_b_captured may remain fixed.

[Equation 2]

K_rate(soc) = (K_a(SOC)/K_b_captured)

K_rate(soc) may be a value between 0 and 1, and even if K_a(soc) becomes greater than K_b_captured, K_rate(soc) may remain at 1.

FIG. 14 is a diagram for explaining examples in which the battery model generator of the LFP battery model generation apparatus according to embodiments of the present disclosure generates a battery model based on a state of lithium in the positive electrode active material of the LFP battery, the state being recorded by the lithium state recorder

during discharging of the LFP battery.

Referring to FIG. 14, the battery model generator 110 may generate a battery model of the LFP battery 1 by classifying, when discharging the LFP battery 1, the state of the lithium distribution into a third circumstance in which lithium ions are not distributed in the peripheral portion of the positive electrode active material of the LFP battery 1, and a fourth circumstance in which lithium ions are distributed in the peripheral portion of the positive electrode active material of the LFP battery 1.

The third circumstance may refer to the circumstance in which lithium ions have been extracted during a previous charging process, resulting in the absence of lithium ion in the peripheral portion of the positive electrode active material. The fourth circumstance may refer to the circumstance in which lithium ions have entered during a previous discharging process, resulting in lithium ions being accumulated in the peripheral portion of the positive electrode active material. The aforementioned lithium distribution may be maintained regardless of whether a rest period exists between a previous state and a current state.

As shown in FIG. 14, in the fourth circumstance, when discharging is performed from an SOC of 40% to an SOC of 300% through an SOC of 35%, starting from a state in which lithium ions are accumulated in the peripheral portion of the positive electrode active material, lithium ions positioned in the peripheral portion are required to move inward through a portion in the rich phase, resulting in high internal resistance. In the fourth circumstance, the correction value K_rate(soc), which reflects the state of lithium in the positive electrode active material, may be set to 1.

As shown in FIG. 14, in the third circumstance, when discharging is performed from an SOC of 50% to an SOC of 40% through an SOC of 45%, starting from a state in which lithium ions are absent in the peripheral portion of the positive electrode active material, lithium ions may enter from the outside of the positive electrode active material and immediately settle in place. Accordingly, internal resistance may gradually increase until the lithium ions fully occupy the most peripheral portion in the poor phase. In the third circumstance, assuming that a lithium distribution end point closest to the peripheral portion of the positive electrode active material of the LFP battery according to the SOC is denoted as K_b(soc), and a lithium distribution start point closest to the peripheral portion of the positive electrode active material of the LFP battery at a moment when discharging starts after a charged state or a rest state following charging is denoted as K_a_captured, the correction value K_rate(soc), which reflects the state of lithium in the positive electrode active material, may be determined by the following equation. Here, K_b(soc) may continuously vary depending on the amount of lithium ions entering from the outside of the positive electrode active material, during discharging, until charging is performed again or a rest state occurs. The value of K_a_captured may remain fixed.

[Equation 3]

$$K_rate(soc) = (K_b(SOC)/K_a_captured)$$

K_rate(soc) may be a value between 0 and 1, and even if K_b(soc) becomes greater than K_a_captured, K_rate(soc) may remain at 1.

According to embodiments of the present disclosure, the state of lithium in the positive electrode active material of the LFP battery 1 according to charging or discharging of the LFP battery 1 may be recorded, and a battery model of the LFP battery 1 may be generated based on the recorded state of lithium in the positive electrode active material. Accordingly, it is possible to record the state of lithium in the positive electrode active material that changes depending on the history of a previous charging or discharging path, define variation in internal resistance depending on a current internal state of the positive electrode that reflects the history of the previous charging or discharging path, and ultimately apply the defined variation to the battery model.

According to embodiments of the present disclosure, a battery model that reflects the internal state of the positive electrode active material that varies depending on the history of the previous charging or discharging path may be generated. Hence, errors in the battery model may be reduced, and the accuracy may be improved, thereby reducing errors in the SOC and the SOH of the battery, which are calculated by the BMS.

FIG. 15 is a flowchart for explaining a method of generating an LFP battery model according to embodiments of the present disclosure.

Referring to FIG. 15, the LFP battery model generation method according to embodiments of the present disclosure may include steps S210 and S220.

Step S210 may include recording, by the lithium state recorder, a state of lithium (Li) in a positive electrode active material of a lithium iron phosphate ($LiFePO_4$ , LFP) battery according to charging or discharging of the LFP battery. In embodiments, step S210 may include recording a distribution state of lithium from a peripheral portion to a center in the positive electrode active material of the LFP battery, the distribution state varying depending on the charging or discharging of the LFP battery.

Step S220 may be a battery model generation step of generating a battery model of the LFP battery by the battery model generator based on the recorded state of lithium in the positive electrode active material. In embodiments, step S220 may include generating the battery model by modeling the LFP battery through adding an additional voltage increment corresponding to a charging or discharging path of the LFP battery, to an open circuit voltage (OCV), reflecting the state of lithium in the positive electrode active material.

In embodiments, step S220 may include generating the battery model of the LFP battery in a form in which an additional voltage increment corresponding to the charging or discharging path of the LFP battery is included in an ECM.

In embodiments, step S220 may further include determining parameters of the ECM in the pattern with the least path-dependent effect of the positive electrode active material for each SOC and each temperature condition at a given c-rate.

In embodiments, step S220 may further include storing a difference between a voltage in the pattern with the greatest path-dependent effect of the positive electrode active material and a voltage in the pattern with the least path-dependent effect in a table for each SOC and each temperature condition at the given c-rate.

In embodiments, step S220 may further include determining an additional voltage increment corresponding to a charging or discharging path of the LFP battery by multiplying the difference between the voltage in the pattern with the greatest path-dependent effect of the positive electrode active material and the voltage in the pattern with the least path-dependent effect for each SOC and each temperature condition at the given c-rate by a correction value that reflects the state of lithium in the positive electrode active material.

The herein-mentioned method of generating an LFP battery model according to embodiments of the present disclosure has been described with reference to the flowchart shown in the drawing. For brief explanation, the method has been illustrated and described as a series of blocks, but the present disclosure is not limited to the order of the blocks. In other words, some blocks may be executed simultaneously with other blocks or in a different order from those illustrated and described in this specification, and various diverges, flow paths, block sequences may also be implemented if they give the equivalent or similar results. In addition, to implement the method described in the specification, it is also possible not to demand all blocks.

In the description with reference to FIG. 15, each step may be further divided into additional steps, or some steps may be combined as fewer steps, based on implementation embodiments of the present disclosure. Furthermore, some steps may be omitted as needed, and a sequence of steps may be changed. In addition, despite other omitted description, the description provided with reference to FIGS. 1 to 14 may be applied to the description provided with reference to FIG. 15. Moreover, the description provided with reference to FIG. 15 may be applied to the description provided with reference to FIGS. 1 to 14.

Hereinafter, materials which may be used in a secondary battery according to embodiments of the present disclosure are described.

**A** compound (e.g., a lithiated intercalation compound) capable of reversible intercalation and deintercalation of lithium may be used as a positive electrode active material. Specifically, one type or more selected among complex oxides of metal, selected among cobalt, manganese, nickel, and a combination of them, and lithium may be used as the positive electrode active material.

The complex oxide may be lithium transition metal complex oxide. A detailed example of the complex oxide may include lithium nickel-based oxide, lithium cobalt-based oxide, lithium manganese-based oxide, a lithium ferrous phosphate-based compound, cobalt-free nickel-manganese-based oxide, or a combination of them.

For example, a compound that is represented as one of the following chemical formulas may be used. $Li_aA_{1-b}X_bO_{2-c}D_c$ (0. 90≤a≤1.8, 0≤b≤0.5, 0≤c≤0.05); $Li_aMn_{2-b}X_bO_{4-c}D_c$ (0.90≤a≤1.8, 0≤b≤0.5, 0≤c≤0.05); $Li_aNi_{1-b-c}Co_bX_cO_{2-\alpha}D_\alpha$ (0. 90≤a≤1.8, 0≤b≤0.5, 0≤c≤0.5, 0<α<2); $Li_aNi_{1-b-c}Mn_bX_cO_{2-\alpha}D_\alpha$ (0. 90≤a≤1.8, 0≤b≤0.5, 0≤c≤0.5, 0<α<2); $Li_aNi_bCo_cL^1{}_{d-}G_eO_2$ (0. 90≤a≤1.8, 0≤b≤0.9, 0≤c≤0.5, 0≤d≤0.5, 0≤e≤0.1); $Li_aNiG_bO_2$ (0.90≤a≤1.8, 0.001≤b≤0.1); $Li_aCoG_bO_2$ (0.90≤a≤1.8, 0.001≤b≤0.1) ; $Li_aMn_{1-b}G_bO_2$ (0.90≤a≤1.8, 0.001≤b≤0.1); $Li_aMn_2G_bO_4$ (0.90≤a≤1.8, 0.001≤b≤0.1); $Li_aMn_{1-g}G_gPO_4$ (0.90≤a≤1.8, 0≤g≤0.5); $Li_{(3-f)}Fe_2(PO_4)_3$ (0≤f≤2); and $Li_aFePO_4$ (0.90≤a≤1.8).

In the chemical formula, A may be Ni, Co, Mn, or a combination of them. X may be Al, Ni, Co, Mn, Cr, Fe, Mg, Sr, V, a rare earth element, or a combination of them; D may be O, F, S, P, or a combination of them. G may be Al, Cr, Mn, Fe, Mg, La, Ce, Sr, V, or a combination of them. $L^1$ may be Mn, Al, or a combination of them.

A positive electrode for a lithium secondary battery may include a current collector and a positive electrode active material layer formed on the current collector. The positive electrode active material layer may include the positive electrode active material, and may further include a binder and/or a conductive material.

Content of the positive electrode active material may be 90 wt.% to 99.5 wt.% with respect to the positive electrode active material layer 100 wt.%. Content of the binder and the conductive material may be 0.5 wt.% to 5 wt.% with respect to the positive electrode active material layer 100 wt.%.

Al may be used as the current collector, but the present disclosure may not be limited thereto.

A negative electrode active material may include a material capable of reversibly Intercalation/deintercalation with respect to lithium ions, lithium metal, an alloy of lithium metal, a material capable of doping and dedoping with respect

to lithium, or transition metal oxide.

The material capable of reversibly Intercalation/deintercalation with respect to lithium ions may include a carbon-based negative electrode active material, for example, crystalline carbon, amorphous carbon, or a combination of them. An example of the crystalline carbon may include graphite, such as natural graphite or synthetic graphite. Examples of the amorphous carbon may include soft or hard carbon, mesophase pitch carbide, and fired coke.

An Si-based negative electrode active material or an Sn-based negative electrode active material may be used as the material capable of doping and dedoping with respect to lithium. The Si-based negative electrode active material may be silicon, a silicon-carbon composite, $SiO_x$ ($0<x<2$), a Si-based alloy, or a combination of them.

The silicon-carbon composite may be a composite of silicon and amorphous carbon. According to an implementation example, the silicon-carbon composite may include silicon particles, and may have a form in which amorphous carbon has been coated on surfaces of silicon particles.

The silicon-carbon composite may further include crystalline carbon. For example, the silicon-carbon composite may include a core including crystalline carbon and silicon particles, and an amorphous carbon coating layer disposed on a surface of the core.

A negative electrode for a lithium secondary battery may include a current collector and a negative electrode active material layer disposed on the current collector. The negative electrode active material layer may include the negative electrode active material, and may further include a binder and/or a conductive material.

For example the negative electrode active material layer may include the negative electrode active material of 90 wt.% to 99 wt.%, the binder of 0.5 wt.% to 5 wt.%, and the conductive material of 0 wt.% to 5 wt.%.

A nonaqueous-based binder, an aqueous-based binder, a dry binder, or a combination of them may be used as the binder. If the aqueous-based binder is used as a binder for the negative electrode, the binder for the negative electrode may further include a cellulose-series compound capable of assigning viscosity.

One selected among nickel foil, stainless steel foil, titanium foil, nickel foam, copper foam, a polymer base on which a conductive metal has been coated, and a combination of them may be used as a current collector for the negative electrode.

An electrolyte for a lithium secondary battery may include a nonaqueous organic solvent and lithium salts.

The nonaqueous organic solvent may play a role as a medium through which ions that are involved in an electrochemical reaction of a battery can move.

The nonaqueous organic solvent may be a carbonate-based, ester-based, ether-based, ketone-based, or alcohol-based solvent, an aprotic solvent, or a combination of them. The carbonate-based, ester-based, ether-based, ketone-based, or alcohol-based solvent, or the aprotic solvent may be used solely, or two types or more of them may be mixed and used as the nonaqueous organic solvent.

Furthermore, if the carbonate-based solvent is used, annular carbonate and chain carbonate may be mixed and used.

A separator may be present between the positive electrode and the negative electrode depending on the type of lithium secondary battery. Polyethylene, polypropylene, and polyvinylidene fluoride, or a multi-layer having two or more layers of them may be used as the separator.

The separator may include a porous base, and a coating layer including an organic matter, an inorganic matter, or a combination of them that is disposed on one or both sides of the porous base.

The organic matter may include a polyvinylidene fluoride-based heavy antibody or (meth)acrylic polymer.

The inorganic matter may include inorganic particles selected among $Al_2O_3$, $SiO_2$, $TiO_2$, $SnO_2$, $CeO_2$, MgO, NiO, CaO, GaO, ZnO, $ZrO_2$, $Y_2O_3$, $SrTiO_3$, $BaTiO_3$, $Mg(OH)_2$, boehmite, and a combination of them, but the present disclosure is not limited thereto.

The organic matter and the inorganic matter may have a form in which the organic matter and the inorganic matter have been mixed in one coating layer or a form in which a coating layer including the organic matter and a coating layer including the inorganic matter have been stacked

Although the present disclosure has been described herein in connection with the limited embodiments and drawings, the present disclosure is not limited to the embodiments but is defined in the appended claims.

Embodiments are set out in the following clauses

1. An apparatus for generating a lithium iron phosphate ($LiFePO_4$, LFP) battery model, the apparatus comprising:

    a lithium state recorder configured to record a state of lithium (Li) in a positive electrode active material of an LFP battery according to charging or discharging of the LFP battery; and
    a battery model generator configured to generate a battery model of the LFP battery based on the recorded state of the lithium in the positive electrode active material,
    wherein the battery model generator generates the battery model by modeling the LFP battery through adding an additional voltage increment corresponding to a charging or discharging path of the LFP battery to an open circuit

voltage (OCV), in consideration of the state of the Li in the positive electrode active material.

2. The apparatus of clause 1, wherein the Li state recorder records a distribution state of the Li from a peripheral portion to a center in the positive electrode active material of the LFP battery, the distribution state varying depending on the charging or discharging of the LFP battery.

3. The apparatus of clause 2, wherein the battery model generator generates the battery model of the LFP battery in a form in which the additional voltage increment corresponding to the charging or discharging path of the LFP battery is included in an equivalent circuit model (ECM).

4. The apparatus of clause 3, wherein the battery model generator determines parameters of the ECM in a pattern with a least path-dependent effect of the positive electrode active material for each state of charge (SOC) and each temperature condition at a set charging and discharging rate (c-rate).

5. The apparatus of clause 4, wherein the battery model generator stores a difference between a voltage in a pattern with a greatest path-dependent effect of the positive electrode active material and a voltage in the pattern with the least path-dependent effect in a table for each SOC and each temperature condition at the set c-rate.

6. The apparatus of clause 5, wherein the battery model generator determines the additional voltage increment corresponding to the charging or discharging path of the LFP battery by multiplying the difference between the voltage in the pattern with the greatest path-dependent effect of the positive electrode active material and the voltage in the pattern with the least path-dependent effect for each SOC and each temperature condition at the set C-rate by a correction value that reflects the state of the Li in the positive electrode active material.

7. The apparatus of clause 6, wherein when the correction value reflecting the state of the Li in the positive electrode active material is denoted as K_rate(soc), and the difference between the voltage in the pattern with the greatest path-dependent effect of the positive electrode active material and the voltage in the pattern with the least path-dependent effect for each SOC and each temperature condition at the set C-rate is denoted as V_path_effect_max(soc) - V_path_effect_min(soc), V_path indicating the additional voltage increment corresponding to the charging or discharging path of the LFP battery is determined by a following equation:

$$V_path(soc) = K_rate(soc) \times \{V_path_effect_max(soc) - V_path_effect_min(soc)\}.$$

8. The apparatus of clause 7, wherein the battery model generator generates the battery model of the LFP battery by classifying, when charging the LFP battery, the state of the Li distribution into a first circumstance in which the Li is not distributed in the peripheral portion of the positive electrode active material of the LFP battery, and a second circumstance in which the Li is distributed in the peripheral portion of the positive electrode active material of the LFP battery.

9. The apparatus of clause 8, wherein in the first circumstance, K_rate(soc) that is the correction value reflecting the state of the Li in the positive electrode active material is 1.

10. The apparatus of clause 8 or clause 9, wherein in the second circumstance, when a Li distribution start point closest to the peripheral portion in the positive electrode active material of the LFP battery according to the SOC is denoted as K_a(soc), and a Li distribution end point closest to the peripheral portion in the positive electrode active material of the LFP battery at a moment when charging starts after a discharged state or a rest state following discharging is denoted as K_b_captured, K_rate(soc) that is the correction value reflecting the state of the Li in the positive electrode active material is determined by a following equation:

$$K_rate(soc) = (K_a(soc)/K_b_captured).$$

11. The apparatus of any of clauses 7 to 10, wherein the battery model generator generates the battery model of the LFP battery by classifying, when discharging the LFP battery, the state of the Li distribution into a third circumstance in which the Li is not distributed in a peripheral portion of the positive electrode active material of the LFP battery, and a fourth circumstance in which the Li is distributed in the peripheral portion of the positive electrode active material of the LFP battery.

12. The apparatus of clause 11, wherein in the fourth circumstance, K_rate(soc) that is the correction value reflecting the state of the Li in the positive electrode active material is 1.

13. The apparatus of clause 12, wherein in the third circumstance, when a Li distribution end point closest to the peripheral portion in the positive electrode active material of the LFP battery according to the SOC is denoted as K_b(soc), and a Li distribution start point closest to the peripheral portion in the positive electrode active material of the LFP battery at a moment when discharging starts after a charged state or a rest state following charging is denoted as K_a_captured, K_rate(soc) that is the correction value reflecting the state of the Li in the positive electrode active material is determined by a following equation:

$$K_rate(soc) = (K_b(soc)/K_a_captured).$$

14. A method of generating a lithium iron phosphate ($LiFePO_4$, LFP) battery model, the method comprising:

a lithium state recording operation of recording, by a lithium state recorder, a state of lithium (Li) in a positive electrode active material of an LFP battery according to charging or discharging of the LFP battery; and
a battery model generation operation of generating, by a battery model generator, a battery model of the LFP battery based on the recorded state of the Li in the positive electrode active material,
wherein the battery model generation operation includes generating the battery model by modeling the LFP battery through adding an additional voltage increment corresponding to a charging or discharging path of the LFP battery to an open circuit voltage (OCV), in consideration of the state of the Li in the positive electrode active material.

15. The method of clause 14, wherein the Li state recording operation comprises recording a distribution state of the Li from a peripheral portion to a center in the positive electrode active material of the LFP battery, the distribution state varying depending on the charging or discharging of the LFP battery.

16. The method of clause 15, wherein the battery model generation operation comprises generating the battery model of the LFP battery in a form in which the additional voltage increment corresponding to the charging or discharging path of the LFP battery is included in an equivalent circuit model (ECM).

17. The method of clause 16, wherein the battery model generation operation further comprises determining parameters of the ECM in a pattern with a least path-dependent effect of the positive electrode active material for each state of charge (SOC) and each temperature condition at a set charging and discharging rate (c-rate).

18. The method of clause 17, wherein the battery model generation operation further comprises storing a difference between a voltage in a pattern with a greatest path-dependent effect of the positive electrode active material and a voltage in the pattern with the least path-dependent effect in a table for each SOC and each temperature condition at the set c-rate.

19. The method of clause 18, wherein the battery model generation operation further comprises determining the additional voltage increment corresponding to the charging or discharging path of the LFP battery by multiplying the difference between the voltage in the pattern with the greatest path-dependent effect of the positive electrode active material and the voltage in the pattern with the least path-dependent effect for each SOC and each temperature condition at the set C-rate by a correction value that reflects the state of the Li in the positive electrode active material.

20. The method of clause 19, wherein the battery model generation operation further comprises determining V_path indicating the additional voltage increment corresponding to the charging or discharging path of the LFP battery by a following equation, when the correction value reflecting the state of the Li in the positive electrode active material is denoted as K_rate(soc), and the difference between the voltage in the pattern with the greatest path-dependent effect of the positive electrode active material and the voltage in the pattern with the least path-dependent effect for each SOC and each temperature condition at the set C-rate is denoted as V_path_effect_max(soc) - V_path_effect_min(soc:

$$V_path(soc) = K_rate(soc) \times \{V_path_effect_max(soc) - V_path_effect_min_(soc)\}.$$

## Claims

1. An apparatus for generating a lithium iron phosphate ($LiFePO_4$, LFP) battery model, the apparatus comprising:

   a lithium state recorder configured to record a state of lithium (Li) in a positive electrode active material of an LFP battery according to charging or discharging of the LFP battery; and
   a battery model generator configured to generate a battery model of the LFP battery based on the recorded state of the lithium in the positive electrode active material,
   wherein the battery model generator is configured to generate the battery model by modeling the LFP battery through adding an additional voltage increment corresponding to a charging or discharging path of the LFP battery to an open circuit voltage (OCV), in consideration of the state of the Li in the positive electrode active material.

2. The apparatus as claimed in claim 1, wherein the Li state recorder is configured to record a distribution state of the Li from a peripheral portion to a center in the positive electrode active material of the LFP battery, the distribution state varying depending on the charging or discharging of the LFP battery.

3. The apparatus as claimed in claim 2, wherein the battery model generator is configured to generate the battery model of the LFP battery in a form in which the additional voltage increment corresponding to the charging or discharging path of the LFP battery is included in an equivalent circuit model (ECM).

4. The apparatus as claimed in claim 3, wherein the battery model generator is configured to determine parameters of the ECM in a pattern with a least path-dependent effect of the positive electrode active material for each state of charge (SOC) and each temperature condition at a set charging and discharging rate (c-rate).

5. The apparatus as claimed in claim 4, wherein the battery model generator is configured to store a difference between a voltage in a pattern with a greatest path-dependent effect of the positive electrode active material and a voltage in the pattern with the least path-dependent effect in a table for each SOC and each temperature condition at the set c-rate.

6. The apparatus as claimed in claim 5, wherein the battery model generator is configured to determine the additional voltage increment corresponding to the charging or discharging path of the LFP battery by multiplying the difference between the voltage in the pattern with the greatest path-dependent effect of the positive electrode active material and the voltage in the pattern with the least path-dependent effect for each SOC and each temperature condition at the set C-rate by a correction value that reflects the state of the Li in the positive electrode active material.

7. The apparatus as claimed in claim 6, wherein when the correction value reflecting the state of the Li in the positive electrode active material is denoted as K_rate(soc), and the difference between the voltage in the pattern with the greatest path-dependent effect of the positive electrode active material and the voltage in the pattern with the least path-dependent effect for each SOC and each temperature condition at the set C-rate is denoted as V_path_effect_max(soc) - V_path_effect_min(soc), V_path indicating the additional voltage increment corresponding to the charging or discharging path of the LFP battery is determined by a following equation:

   V_path(soc) = K_rate(soc) × {V_path_effect_max(soc) - V_path_effect_min(soc)}.

8. The apparatus as claimed in claim 7, wherein the battery model generator is configured to generate the battery model of the LFP battery by classifying, when charging the LFP battery, the state of the Li distribution into a first circumstance in which the Li is not distributed in the peripheral portion of the positive electrode active material of the LFP battery, and a second circumstance in which the Li is distributed in the peripheral portion of the positive electrode active material of the LFP battery.

9. The apparatus as claimed in claim 8, wherein in the first circumstance, K_rate (soc) that is the correction value reflecting the state of the Li in the positive electrode active material is 1.

10. The apparatus as claimed in claim 8 or claim 9, wherein in the second circumstance, when a Li distribution start point closest to the peripheral portion in the positive electrode active material of the LFP battery according to the SOC is denoted as K_a(soc), and a Li distribution end point closest to the peripheral portion in the positive electrode active

material of the LFP battery at a moment when charging starts after a discharged state or a rest state following discharging is denoted as K_b_captured, K_rate(soc) that is the correction value reflecting the state of the Li in the positive electrode active material is determined by a following equation:

$$K_rate(soc) = (K_a(soc)/K_b_captured).$$

**11.** The apparatus as claimed in any of claims 7 to 10, wherein the battery model generator is configured to generate the battery model of the LFP battery by classifying, when discharging the LFP battery, the state of the Li distribution into a third circumstance in which the Li is not distributed in a peripheral portion of the positive electrode active material of the LFP battery, and a fourth circumstance in which the Li is distributed in the peripheral portion of the positive electrode active material of the LFP battery.

**12.** The apparatus as claimed in claim 11, wherein in the fourth circumstance, K_rate(soc) that is the correction value reflecting the state of the Li in the positive electrode active material is 1.

**13.** The apparatus as claimed in claim 12, wherein in the third circumstance, when a Li distribution end point closest to the peripheral portion in the positive electrode active material of the LFP battery according to the SOC is denoted as K_b(soc), and a Li distribution start point closest to the peripheral portion in the positive electrode active material of the LFP battery at a moment when discharging starts after a charged state or a rest state following charging is denoted as K_a_captured, K_rate(soc) that is the correction value reflecting the state of the Li in the positive electrode active material is determined by a following equation:

$$K_rate(soc) = (K_b(soc)/K_a_captured).$$

**14.** A method of generating a lithium iron phosphate ($LiFePO_4$, LFP) battery model, the method comprising:

a lithium state recording operation of recording, by a lithium state recorder, a state of lithium (Li) in a positive electrode active material of an LFP battery according to charging or discharging of the LFP battery; and
a battery model generation operation of generating, by a battery model generator, a battery model of the LFP battery based on the recorded state of the Li in the positive electrode active material,
wherein the battery model generation operation includes generating the battery model by modeling the LFP battery through adding an additional voltage increment corresponding to a charging or discharging path of the LFP battery to an open circuit voltage (OCV), in consideration of the state of the Li in the positive electrode active material.

FIG. 1

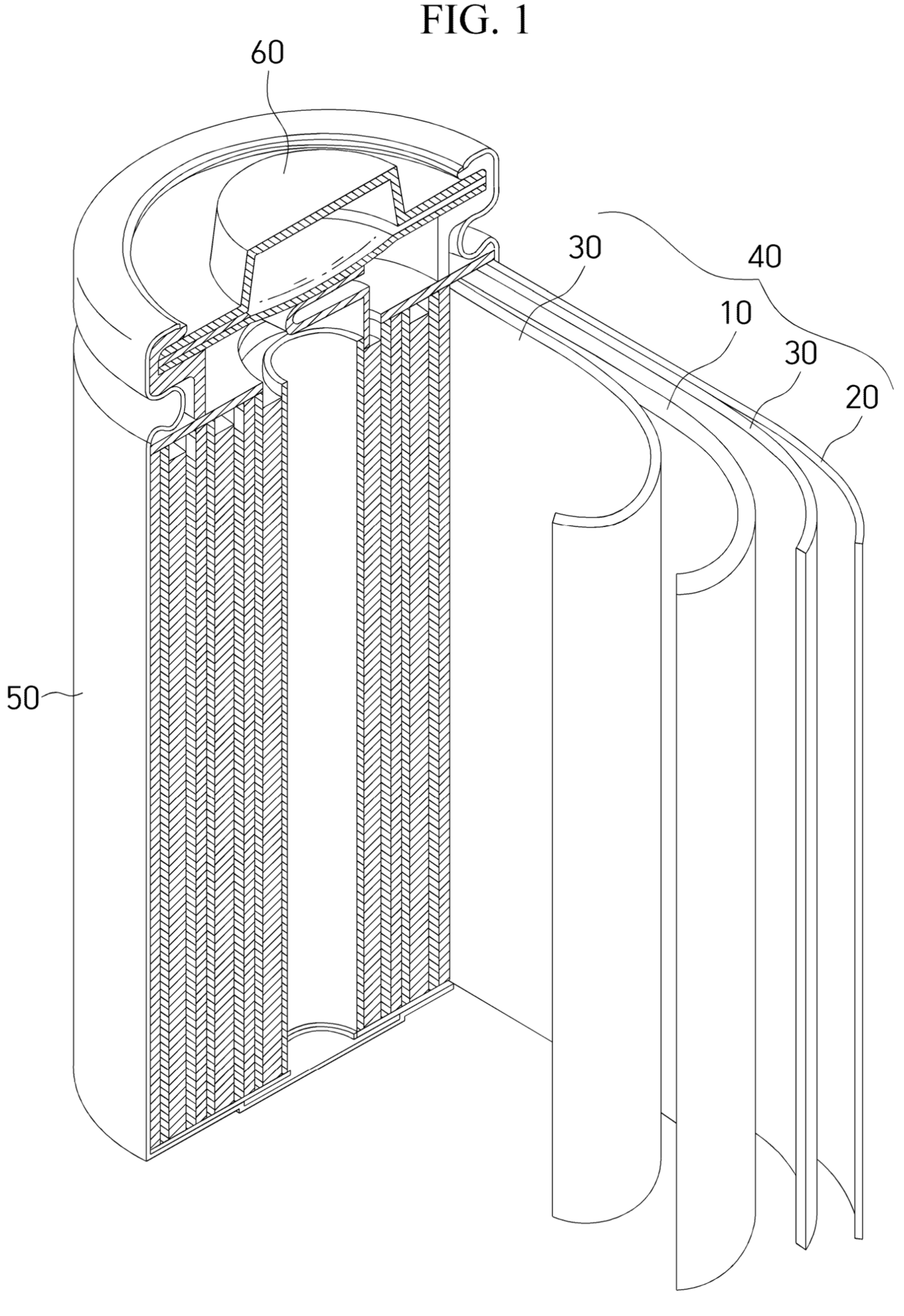

FIG. 2

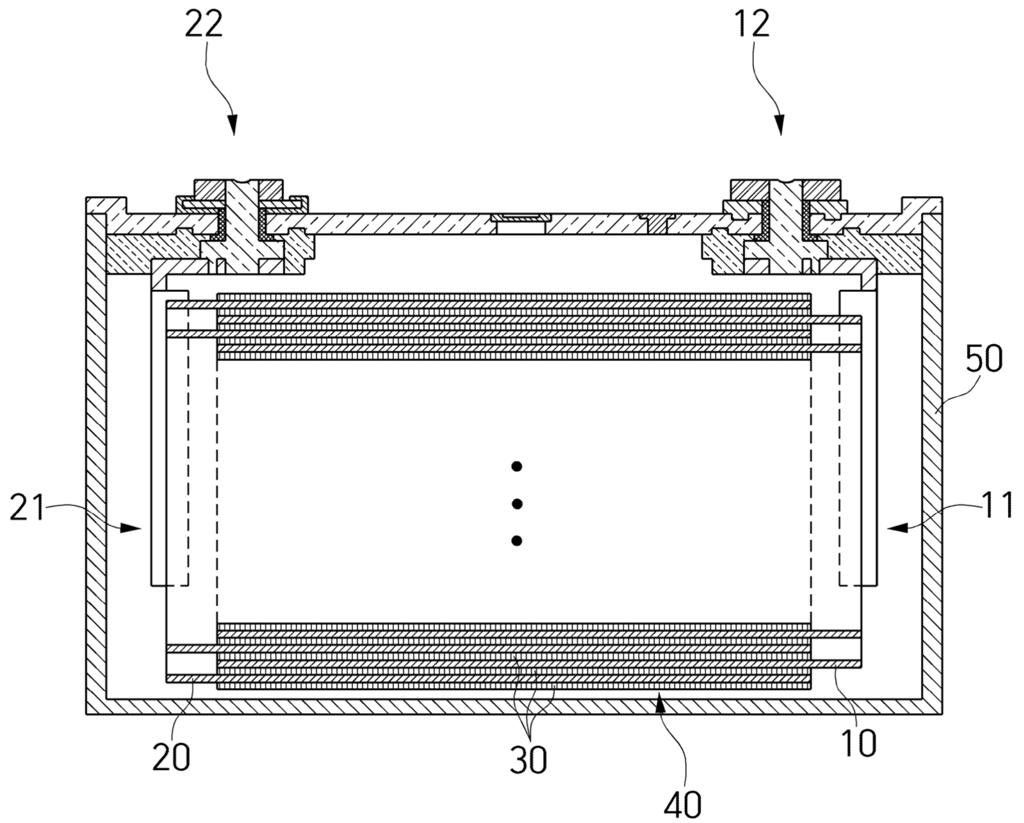

FIG. 3

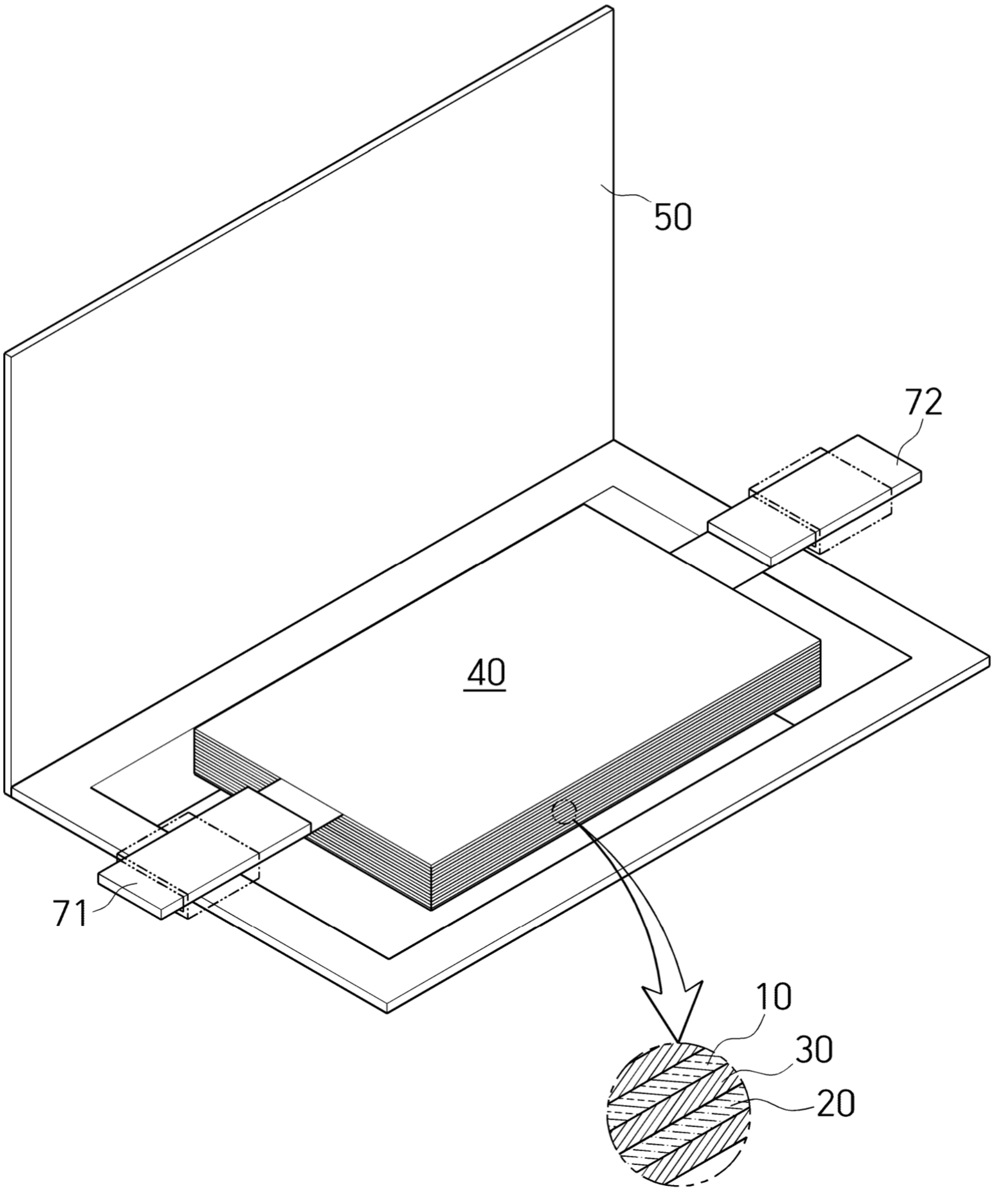

FIG. 4

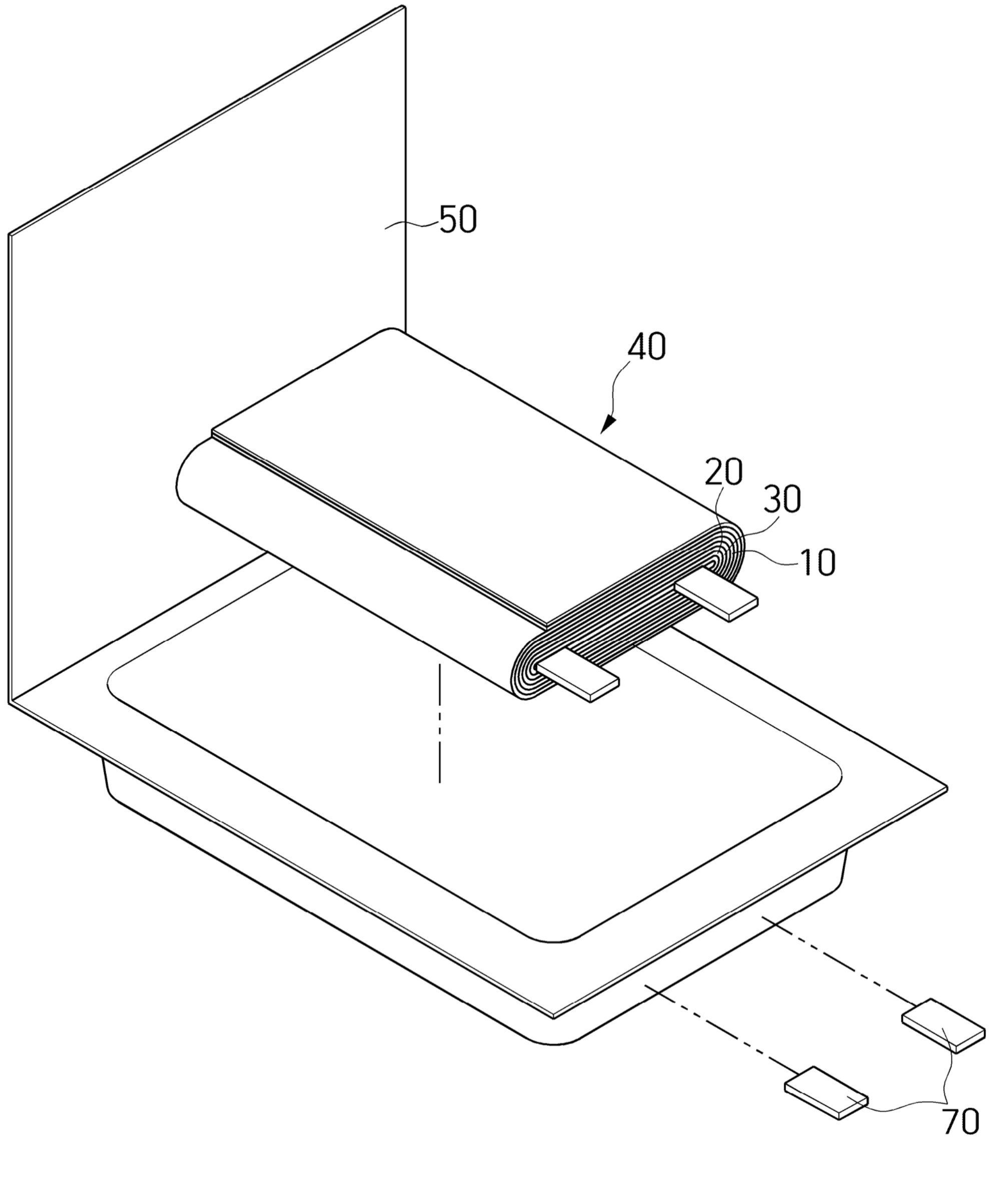

FIG. 5

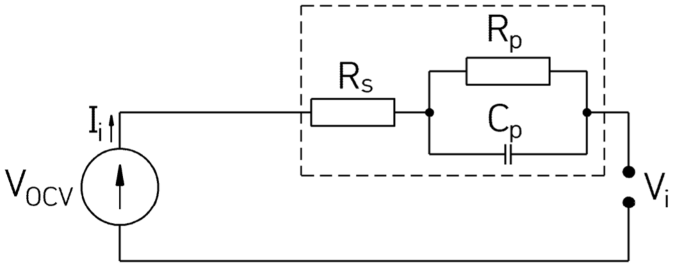
$R_p$
$R_s$
$I_i$
$C_p$
$V_{OCV}$
$V_i$

FIG. 6

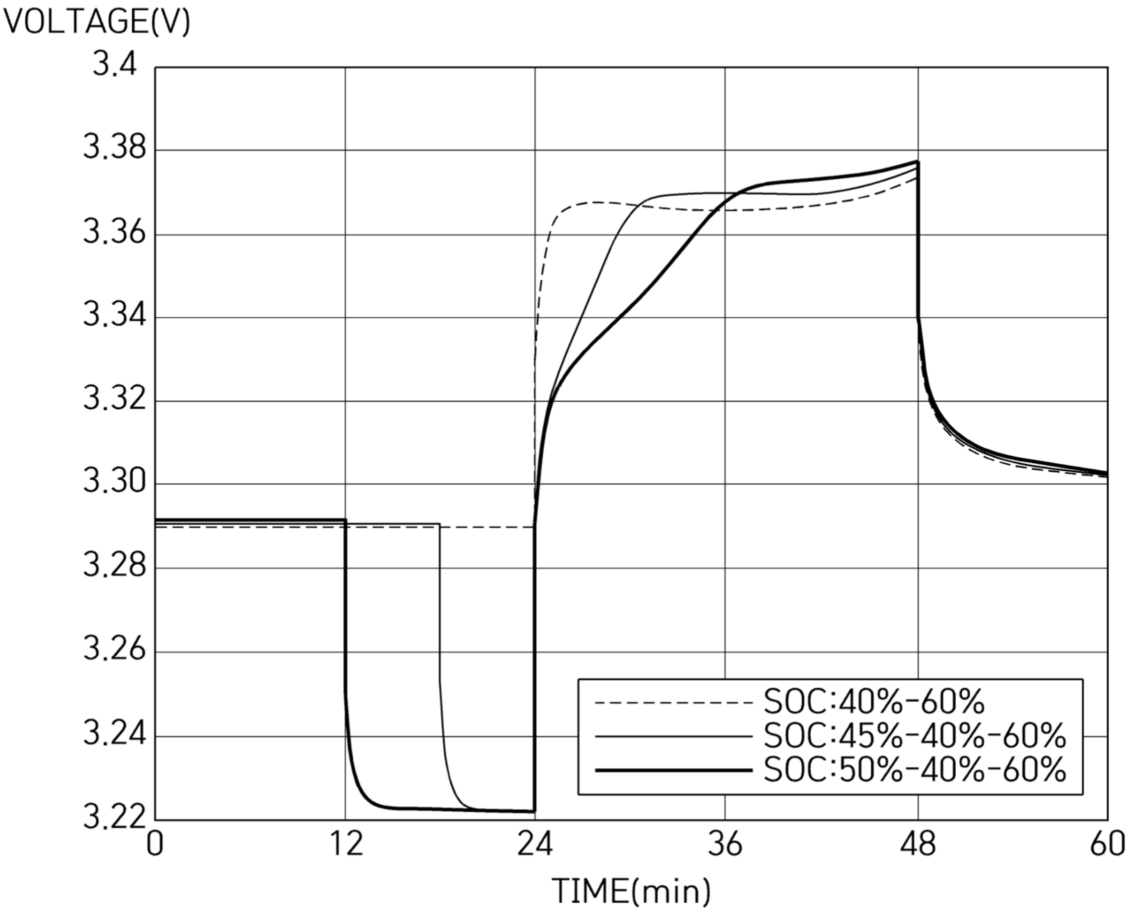
VOLTAGE(V)
3.4
3.38
3.36
3.34
3.32
3.30
3.28
3.26
3.24
3.22
0
12
24
36
48
60
TIME(min)
SOC:40%-60%
SOC:45%-40%-60%
SOC:50%-40%-60%

FIG. 7

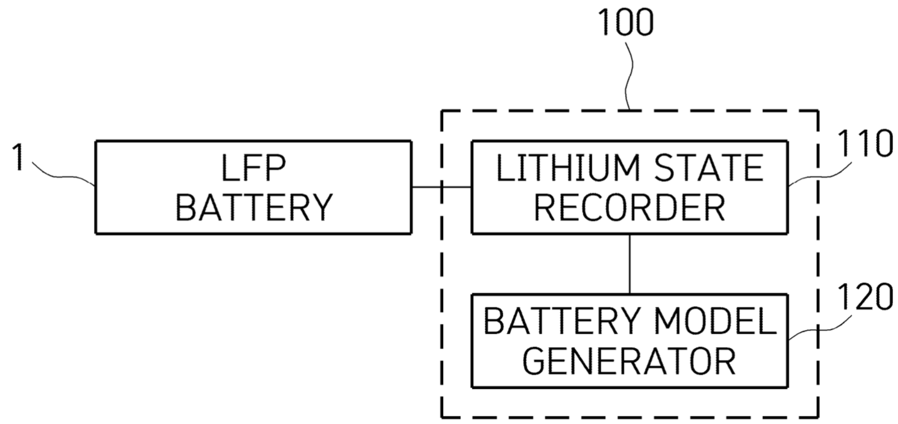
100
1
LFP
BATTERY
LITHIUM STATE
RECORDER
110
BATTERY MODEL
GENERATOR
120

FIG. 8

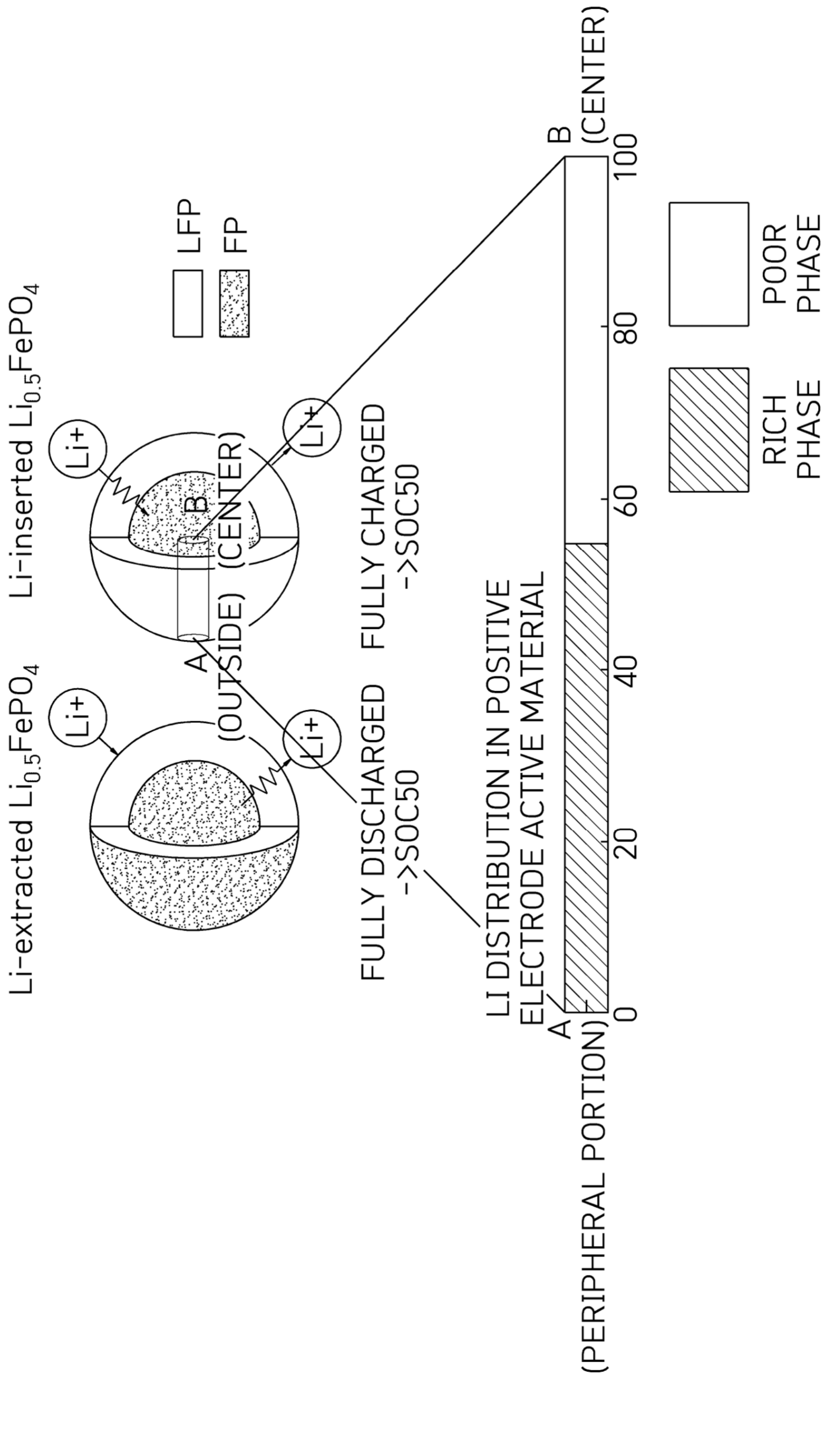
Li-extracted $Li_{0.5}FePO_4$
Li-inserted $Li_{0.5}FePO_4$
Li+
LFP
FP
A
B
(OUTSIDE)
(CENTER)
FULLY DISCHARGED
->SOC50
FULLY CHARGED
->SOC50
LI DISTRIBUTION IN POSITIVE
ELECTRODE ACTIVE MATERIAL
(PERIPHERAL PORTION)
0
20
40
60
80
100
RICH
PHASE
POOR
PHASE

FIG. 9

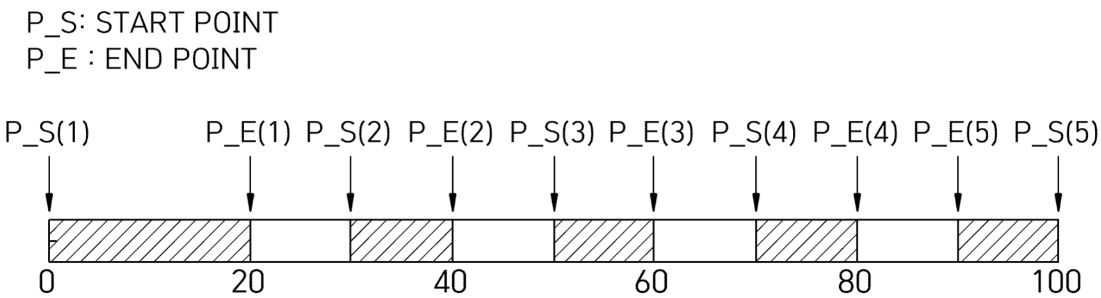
P_S: START POINT
P_E : END POINT
P_S(1)
P_E(1)
P_S(2)
P_E(2)
P_S(3)
P_E(3)
P_S(4)
P_E(4)
P_E(5)
P_S(5)
0
20
40
60
80
100

FIG. 10

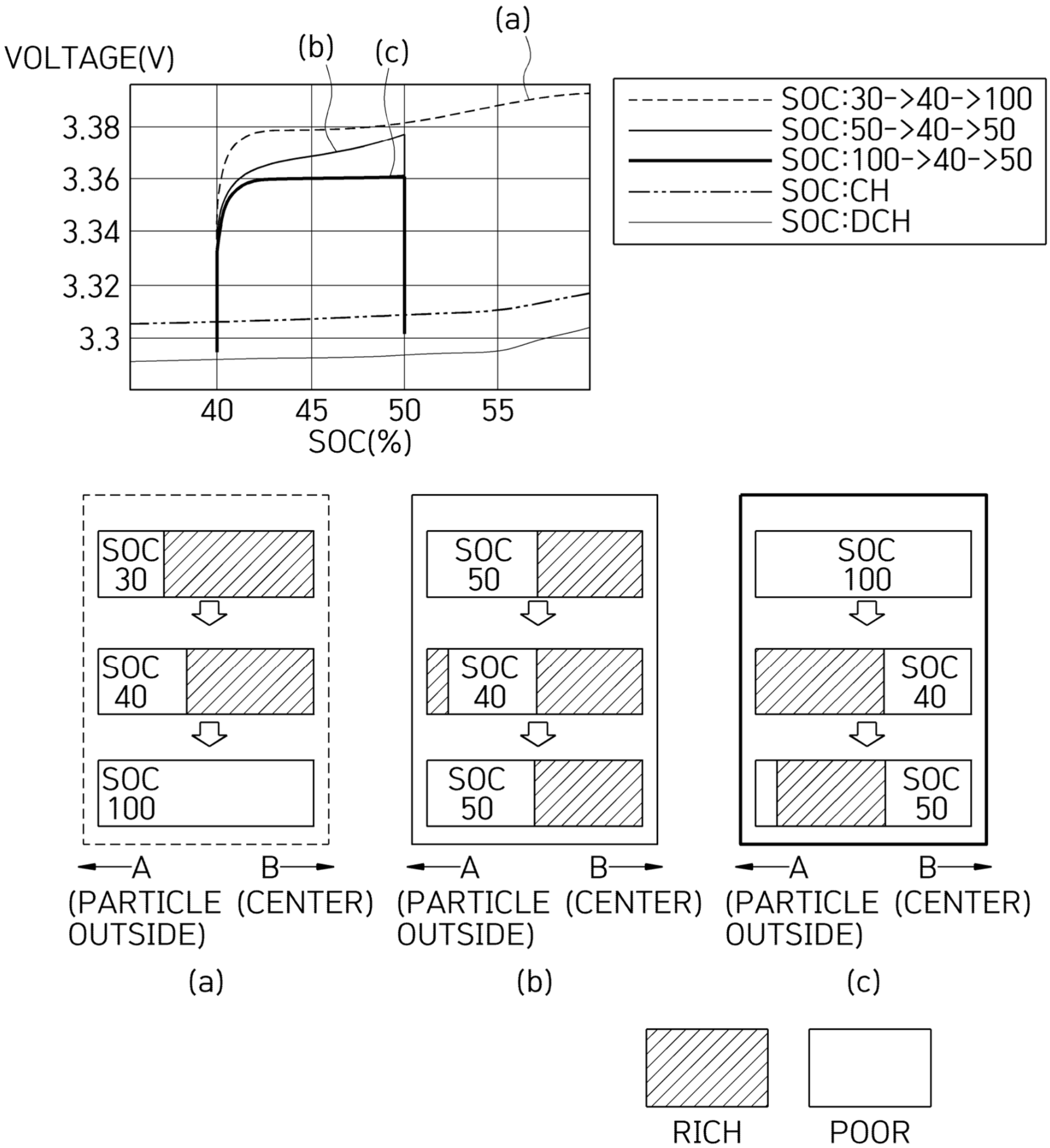

VOLTAGE(V)
(a)
(b)
(c)
3.38
3.36
3.34
3.32
3.3
40
45
50
55
SOC(%)
SOC:30->40->100
SOC:50->40->50
SOC:100->40->50
SOC:CH
SOC:DCH
SOC 30
SOC 40
SOC 100
SOC 50
SOC 40
SOC 50
SOC 100
SOC 40
SOC 50
A (PARTICLE OUTSIDE)
B (CENTER)
(a)
(b)
(c)
RICH PHASE
POOR PHASE

FIG. 11

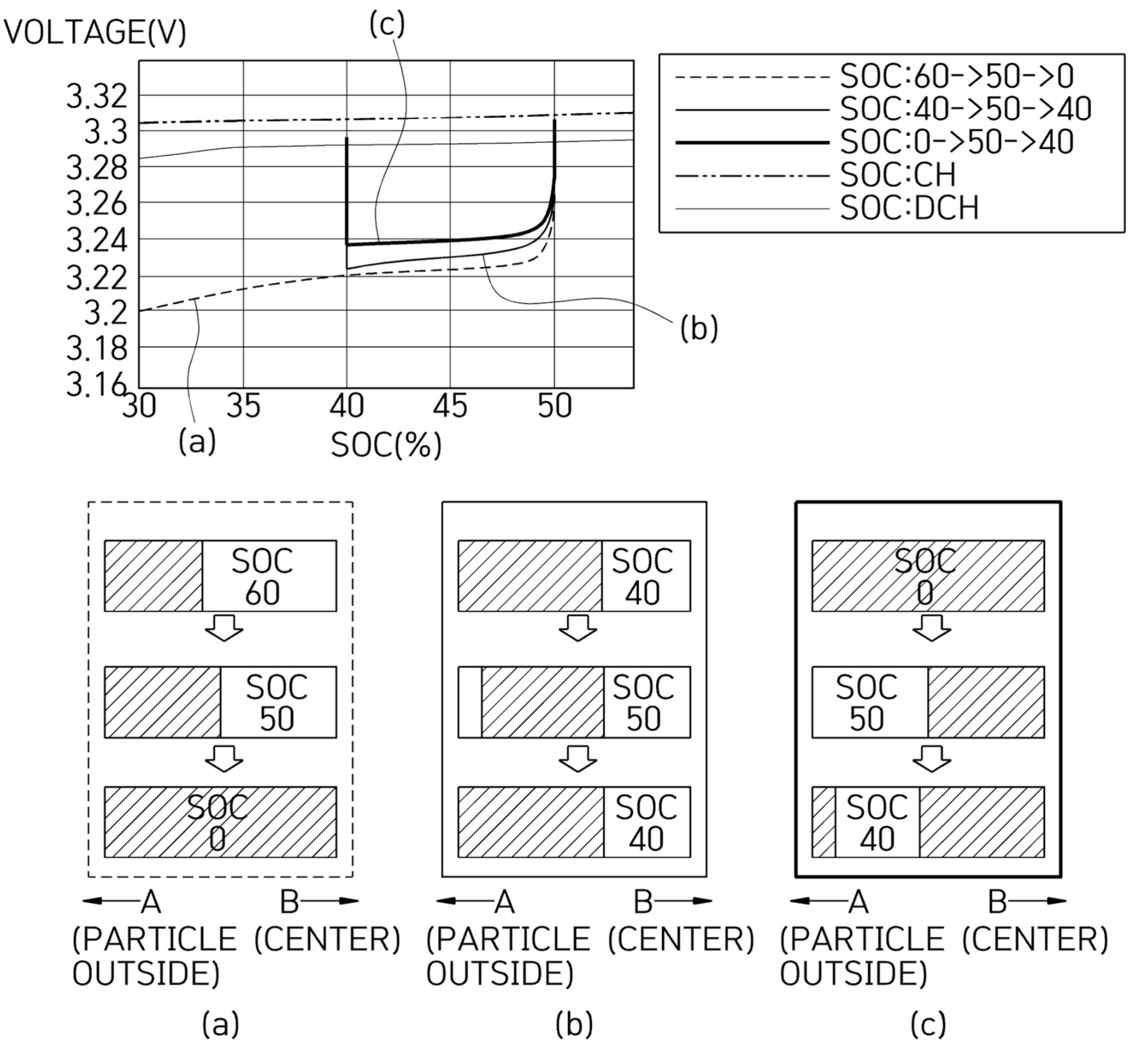
VOLTAGE(V)
(c)
3.32
3.3
3.28
3.26
3.24
3.22
3.2
3.18
3.16
30
35
40
45
50
SOC(%)
(a)
(b)
SOC:60->50->0
SOC:40->50->40
SOC:0->50->40
SOC:CH
SOC:DCH
SOC 60
SOC 50
SOC 0
SOC 40
SOC 50
SOC 40
SOC 0
SOC 50
SOC 40
A
B
(PARTICLE OUTSIDE)
(CENTER)
(a)
(b)
(c)

FIG. 12

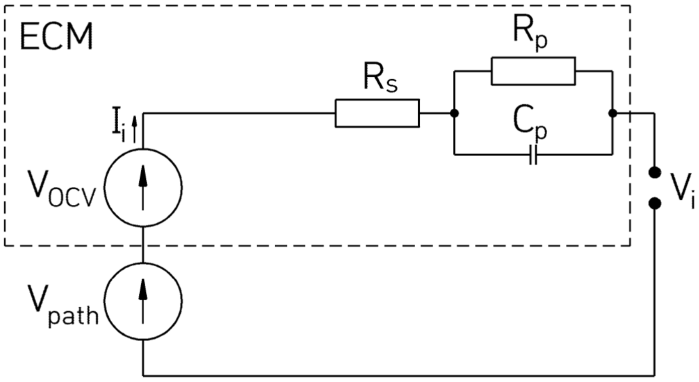

FIG. 13

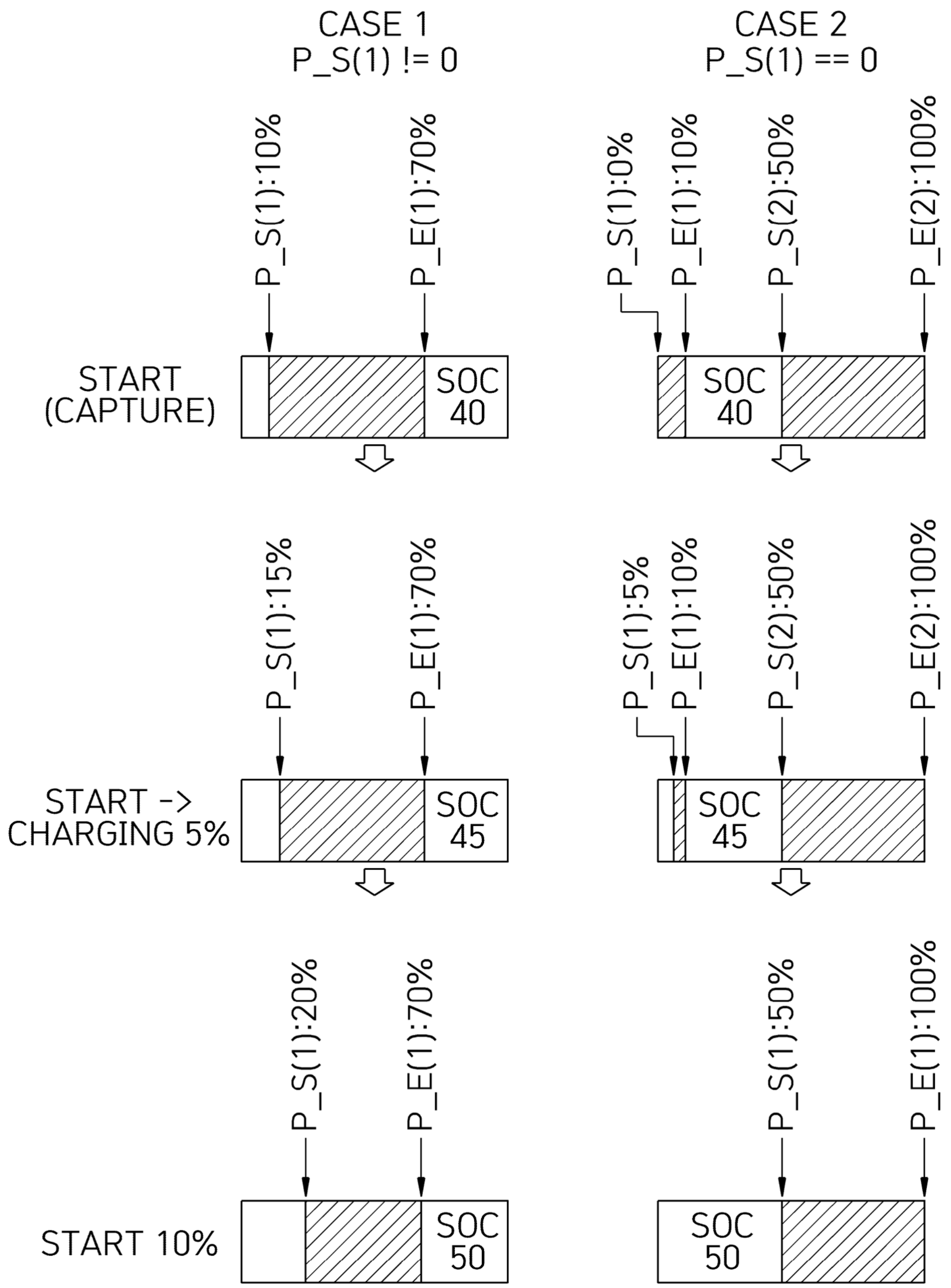
CASE 1
P_S(1) != 0
CASE 2
P_S(1) == 0
P_S(1):10%
P_E(1):70%
P_S(1):0%
P_E(1):10%
P_S(2):50%
P_E(2):100%
START
(CAPTURE)
SOC
40
SOC
40
P_S(1):15%
P_E(1):70%
P_S(1):5%
P_E(1):10%
P_S(2):50%
P_E(2):100%
START ->
CHARGING 5%
SOC
45
SOC
45
P_S(1):20%
P_E(1):70%
P_S(1):50%
P_E(1):100%
START 10%
SOC
50
SOC
50

FIG. 14

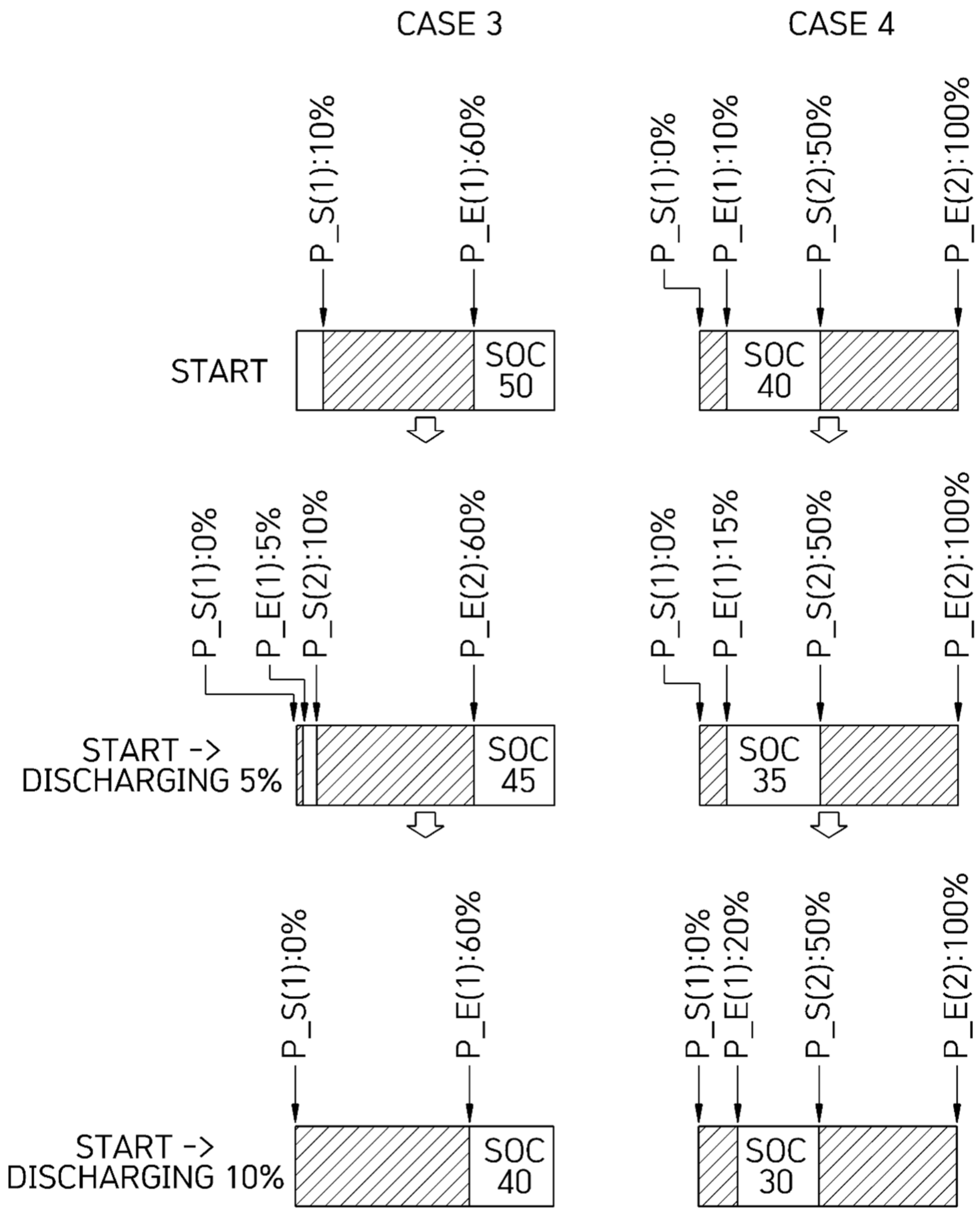
CASE 3
CASE 4
P_S(1):10%
P_E(1):60%
START
SOC 50
P_S(1):0%
P_E(1):10%
P_S(2):50%
P_E(2):100%
SOC 40
P_S(1):0%
P_E(1):5%
P_S(2):10%
P_E(2):60%
START -> DISCHARGING 5%
SOC 45
P_S(1):0%
P_E(1):15%
P_S(2):50%
P_E(2):100%
SOC 35
P_S(1):0%
P_E(1):60%
START -> DISCHARGING 10%
SOC 40
P_S(1):0%
P_E(1):20%
P_S(2):50%
P_E(2):100%
SOC 30

FIG. 15

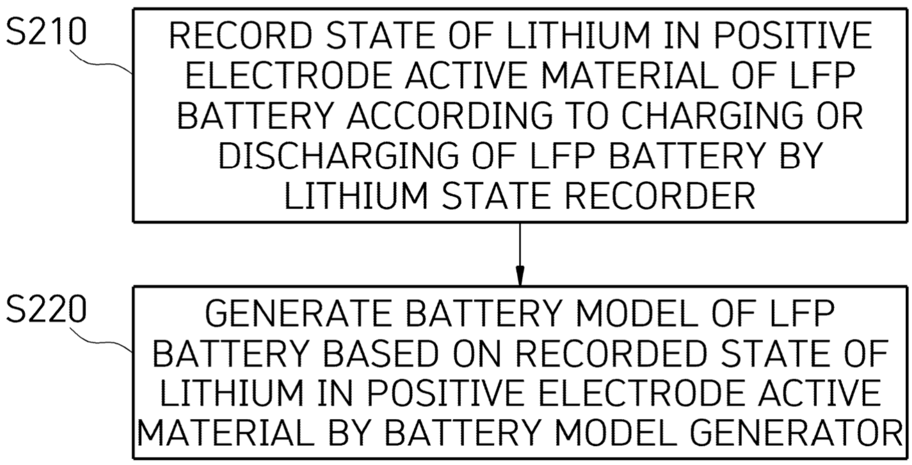
S210
RECORD STATE OF LITHIUM IN POSITIVE ELECTRODE ACTIVE MATERIAL OF LFP BATTERY ACCORDING TO CHARGING OR DISCHARGING OF LFP BATTERY BY LITHIUM STATE RECORDER
S220
GENERATE BATTERY MODEL OF LFP BATTERY BASED ON RECORDED STATE OF LITHIUM IN POSITIVE ELECTRODE ACTIVE MATERIAL BY BATTERY MODEL GENERATOR

Europäisches Patentamt
European Patent Office
Office européen des brevets

# EUROPEAN SEARCH REPORT

Application Number
EP 25 22 3610

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2024/236604 A1 (SMARTKOSH TECH PRIVATE LIMITED [IN]) 21 November 2024 (2024-11-21) | 1,14 | INV. H01M4/58 G01R31/367 G01R31/378 G01R31/382 G01R31/387 H01M10/42 H01M10/48 |
| A | * claims 1-10 * * paragraphs [0005], [0008] * ----- | 2-13 | |
| X | WO 2012/135148 A1 (QNOVO INC [US]; MALUF NADIM [US] ET AL.) 4 October 2012 (2012-10-04) | 1,14 | |
| A | * claims 1-23 * ----- | 2-13 | |
| X | HASIB SHAHID A. ET AL: "A Comprehensive Review of Available Battery Datasets, RUL Prediction Approaches, and Advanced Battery Management", IEEE ACCESS IEEE, USA, vol. 9, 14 June 2021 (2021-06-14), pages 86166-86193, XP011861635, DOI: 10.1109/ACCESS.2021.3089032 [retrieved on 2021-06-17] | 1,14 | |
| A | * page 86172, right-hand column, paragraph G.1) - page 86173, left-hand column * ----- | 2-13 | TECHNICAL FIELDS SEARCHED (IPC) |
| A | CN 107 255 786 A (ZHONGSHAN POLYTECHNIC) 17 October 2017 (2017-10-17) * claims 1-6 * ----- | 1-14 | H01M G01R |

The present search report has been drawn up for all claims

1

| Place of search | Date of completion of the search | Examiner |
|---|---|---|
| Munich | 15 April 2026 | Haering, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..........
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 22 3610

This annex lists the patent family members relating to the patent documents cited in the above-mentioned European search report. The members are as contained in the European Patent Office EDP file on
The European Patent Office is in no way liable for these particulars which are merely given for the purpose of information.

15-04-2026

| Patent document cited in search report | Publication date | Patent family member(s) | Publication date |
|---|---|---|---|
| WO 2024236604 A1 | 21-11-2024 | NONE | |
| WO 2012135148 A1 | 04-10-2012 | US 2012200266 A1 | 09-08-2012 |
| | | US 2015153417 A1 | 04-06-2015 |
| | | WO 2012135148 A1 | 04-10-2012 |
| CN 107255786 A | 17-10-2017 | NONE | |

EPO FORM P0459

For more details about this annex : see Official Journal of the European Patent Office, No. 12/82